(19) **Europäisches Patentamt European Patent Office Office européen des brevets**

(11) **EP 4 268 374 B1**

(12) **FASCICULE DE BREVET EUROPEEN**

(45) Date de publication et mention de la délivrance du brevet:
**28.01.2026 Bulletin 2026/05**

(21) Numéro de dépôt: **21848168.7**

(22) Date de dépôt: **09.12.2021**

(51) Classification Internationale des Brevets (IPC):
**H03M 7/30** (2006.01)    **G10L 19/008** (2013.01)

(52) Classification Coopérative des Brevets (CPC):
**H03M 7/3082; G10L 19/008; H03M 7/3068**

(86) Numéro de dépôt international:
**PCT/FR2021/052257**

(87) Numéro de publication internationale:
**WO 2022/136760 (30.06.2022 Gazette 2022/26)**

(54) **CODAGE OPTIMISE DE MATRICES DE ROTATIONS POUR LE CODAGE D'UN SIGNAL AUDIO MULTICANAL**

OPTIMIERTE CODIERUNG VON ROTATIONSMATRIZEN ZUR CODIERUNG EINES MEHRKANALIGEN AUDIOSIGNALS

OPTIMISED ENCODING OF ROTATION MATRICES FOR ENCODING A MULTICHANNEL AUDIO SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2020 FR 2013954**

(43) Date de publication de la demande:
**01.11.2023 Bulletin 2023/44**

(73) Titulaire: **Orange**
**92130 Issy-les-Moulineaux (FR)**

(72) Inventeur: **RAGOT, Stéphane**
**92326 CHÂTILLON CEDEX (FR)**

(56) Documents cités:
**EP-A1- 3 706 119**

• **MAHÉ PIERRE ET AL: "First-order ambisonic coding with quaternion-based interpolation of PCA rotation matrices FIRST-ORDER AMBISONIC CODING WITH QUATERNION-BASED INTERPOLATION OF PCA ROTATION MATRICES", EAA SPATIAL AUDIO SIGNAL PROCESSING SYMPOSIUM, 30 August 2019 (2019-08-30), Paris, France, pages 7 - 12, XP055835006, Retrieved from the Internet <URL:https://hal.archives-ouvertes.fr/hal-02275181/document> [retrieved on 20210825], DOI: 10.25836/sasp.2019.19**
• **MAHÉ PIERRE ET AL: "First-Order Ambisonic Coding with PCA Matrixing and Quaternion-Based Interpolation", PROCEEDINGS OF THE 22 ND INTERNATIONAL CONFERENCE ON DIGITAL AUDIO EFFECTS, 2 September 2019 (2019-09-02), pages 1 - 8, XP055835009, Retrieved from the Internet <URL:https://www.dafx.de/paper-archive/2019/DAFx2019_paper_15.pdf> [retrieved on 20210825]**

**Description**

La présente invention concerne le codage/décodage de données sonores spatialisées, notamment en contexte ambiophonique (noté ci-après également « ambisonique »).

Les codeurs/décodeurs (ci-après appelés « codecs ») qui sont utilisés actuellement en téléphonie mobile sont mono (un seul canal de signal pour une restitution sur un seul haut-parleur). Le codec 3GPP EVS (pour « Enhanced Voice Services ») permet d'offrir une qualité « Super-HD » (aussi appelée voix « Haute Définition Plus » ou HD+) avec une bande audio en bande super-élargie (SWB pour « super-wideband » en anglais) pour des signaux échantillonnés à 32 ou 48 kHz ou pleine bande (FB pour « Fullband ») pour des signaux échantillonnés à 48 kHz ; la largeur de bande audio est de 14,4 à 16 kHz en mode SWB (de 9,6 à 128 kbit/s) et de 20 kHz en mode FB (de 16,4 à 128 kbit/s).

La prochaine évolution de qualité dans les services conversationnels proposés par les opérateurs devrait être constituée par les services immersifs, en utilisant des terminaux tels que des smartphones équipés de plusieurs microphones ou des équipements de conférence audio spatialisée ou de visioconférence de type télé-présence ou vidéo 360°, ou encore des équipements de partage de contenus audio « live », avec un rendu sonore spatialisé en 3D autrement plus immersif qu'une simple restitution stéréo 2D. Avec les usages de plus en plus répandus d'écoute sur téléphone mobile avec un casque audio et l'apparition d'équipements audio avancés (accessoires tels qu'un microphone 3D, assistants vocaux avec antennes acoustiques, casques de réalité virtuelle, etc.) la captation et le rendu de scènes sonores spatialisées sont désormais assez répandus pour offrir une expérience de communication immersive.

A ce titre, la future norme 3GPP « IVAS » (pour « Immersive Voice And Audio Services ») propose l'extension du codec EVS à l'audio immersif en acceptant comme format d'entrée du codec au moins les formats de son spatialisé listés ci-dessous (et leurs combinaisons) :

- Format multicanal (channel-based en anglais) de type stéréo ou 5.1 où chaque canal vient alimenter un haut-parleur (par exemple L et R en stéréo ou L, R, Ls, Rs et C en 5.1) ;
- Format objet (object-based en anglais) où des objets sonores sont décrits comme un signal audio (en général mono) associé à des métadonnées décrivant les attributs de cet objet (position dans l'espace, largeur spatiale de la source, etc.),
- Format ambisonique (scene-based en anglais) qui décrit le champ sonore en un point donné, en général capté par un microphone sphérique ou synthétisé dans le domaine des harmoniques sphériques.

On s'intéresse ci-après typiquement au codage d'un son au format ambisonique, à titre d'exemple de réalisation (au moins certains aspects présentés en lien avec l'invention ci-après pouvant également s'appliquer à d'autres formats que de l'ambisonique).

L'ambisonique est une méthode d'enregistrement (« codage » au sens acoustique) de son spatialisé et un système de reproduction (« décodage » au sens acoustique). Un microphone ambisonique (à l'ordre 1) comprend au moins quatre capsules (typiquement de type cardioïde ou sous-cardioïde) arrangées sur une grille sphérique, par exemple les sommets d'un tétraèdre régulier. Les canaux audio associés à ces capsules s'appellent le « A-format ». Ce format est converti dans un « B-format », dans lequel le champ sonore est décomposé en quatre composantes (harmoniques sphériques) notées W, X, Y, Z, qui correspondent à quatre microphones virtuels coïncidents. La composante W correspond à une captation omnidirectionnelle du champ sonore alors que les composantes X, Y et Z, plus directives, sont assimilables à des microphones à gradients de pression orientés suivant les trois axes orthogonaux de l'espace. Un système ambisonique est un système flexible dans le sens où l'enregistrement et la restitution sont séparés et découplés. Il permet un décodage (au sens acoustique) sur une configuration quelconque de haut-parleurs (par exemple, binaural, son « surround » de type 5.1 ou périphonie (avec élévation) de type 7.1.4). L'approche ambisonique peut être généralisée à plus de quatre canaux en B-format et cette représentation généralisée est couramment nommée « HOA » (pour « Higher-Order Ambisonics »). Le fait de décomposer le son sur plus d'harmoniques sphériques améliore la précision spatiale de restitution lors d'un rendu sur haut-parleurs.

Un signal ambisonique à l'ordre M comprend $K=(M+1)^2$ composantes et, à l'ordre 1 (si M=1), on retrouve les quatre composantes W, X, Y, et Z, couramment appelé FOA (pour First-Order Ambisonics). Il existe aussi une variante dite « planaire » de l'ambisonique (W, X, Y) qui décompose le son défini dans un plan qui est en général le plan horizontal (où Z=0). Dans ce cas, le nombre de composantes est K =2M+1 canaux. L'ambisonique d'ordre 1 (4 canaux : W, X, Y, Z), l'ambisonique d'ordre 1 planaire (3 canaux : W, X, Y), l'ambisonique d'ordre supérieur sont tous désignés ci-après par « ambisonique » indistinctement pour faciliter la lecture, les traitements présentés étant applicables indépendamment du type planaire ou non et du nombre de composantes ambisoniques. Si toutefois dans certains passages il est besoin de faire une distinction, les termes « ambisonique d'ordre 1 » et « ambisonique d'ordre 1 planaire » sont utilisés.

Par la suite, on appellera « signal ambisonique » un signal en B-format à un ordre prédéterminé avec un certain nombre de composantes ambisoniques. Dans des variantes, le signal ambisonique peut être défini dans un autre format tel que le A-format ou des canaux précombinés par matriçage fixe.

Les signaux à traiter par le codeur/décodeur se présentent comme des successions de blocs d'échantillons sonores appelés « trames » ou « sous-trames » ci-après.

En outre, ci-après, les notations mathématiques suivent la convention suivante :

- Scalaire : s ou N(minuscule pour les variables ou majuscule pour les constantes)
- Vecteur : q(minuscule, gras et italique)
- Matrice : *M* (majuscule, gras et italique)

L'approche la plus simple pour coder un signal ambisonique consiste à utiliser un codeur mono (par exemple EVS) et à appliquer en parallèle ce codeur mono à tous les canaux avec éventuellement une allocation des bits différente en fonction de chaque canal d'entrée. Cette approche est appelée ici « multi-mono ». On peut étendre l'approche multi-mono à du codage multi-stéréo (où des paires de canaux sont codées séparément par un codec stéréo) ou plus généralement à l'utilisation de plusieurs instances parallèles d'un même codec cœur.

Dans un codage multi-mono, le signal d'entrée est divisé en canaux (mono) qui sont codés individuellement. Après décodage, les canaux sont recombinés. La qualité associée varie selon le codage mono utilisé, et elle n'est en général satisfaisante qu'à très haut débit, par exemple avec un débit d'au moins 48 kbit/s par canal mono pour un codage EVS. Ainsi à l'ordre 1 on obtient un débit minimal de 4x48 = 192 kbit/s.

L'approche de codage multi-mono ne prenant pas en compte la corrélation entre canaux, elle produit à bas débit des déformations spatiales avec l'ajout de différents artéfacts comme l'apparition de sources sonores fantômes, de bruits diffus ou de déplacements des trajectoires de sources sonores. Ainsi, le codage d'un signal ambisonique selon cette approche engendre des dégradations de la spatialisation.

Différentes solutions plus avancées ont été proposées pour coder des signaux ambisoniques. On s'intéresse dans l'invention à une approche particulière de codage ambisonique, utilisant la quantification et l'interpolation de matrices de rotations, comme décrit par exemple dans la demande de brevet WO2020177981.

Dans cette approche, des matrices de rotation 4x4 (issues d'une analyse PCA/KLT telle que décrite par exemple dans la demande de brevet suscitée) sont converties par exemple en 6 angles d'Euler généralisés, qui sont codés par quantification scalaire uniforme, avant d'appliquer une conversion inverse, pour retrouver des matrices de rotations décodées, puis d'appliquer une interpolation par sous-trames dans le domaine des quaternions. On rappelle qu'une méthode de conversion d'une matrice de rotation en angles d'Euler généralisés est donnée dans l'article « Generalization of Euler Angles to N-Dimensional Orthogonal Matrices » de David K. Hoffman, Richard C. Raffenetti, and Klaus Ruedenberg, paru dans Journal of Mathematical Physics 13, 528 (1972).

La stratégie de ce type de codage ambisonique est de dé-corréler au maximum les canaux du signal ambisonique et de les coder ensuite séparément avec un codec cœur (par exemple multi-mono). Cette stratégie permet de limiter les artéfacts dans le signal ambisonique décodé. Plus particulièrement, on applique une décorrélation optimisée des signaux d'entrée avant codage (par exemple multi-mono). Par ailleurs, le domaine des quaternions permet d'interpoler les matrices de transformation calculées pour l'analyse PCA/KLT plutôt que de répéter plusieurs fois par trame une décomposition en valeurs propres et vecteurs propres ; les matrices de transformation étant des matrices de rotation, au décodage, l'opération de matriçage inverse s'effectue simplement en transposant la matrice appliquée au codage.

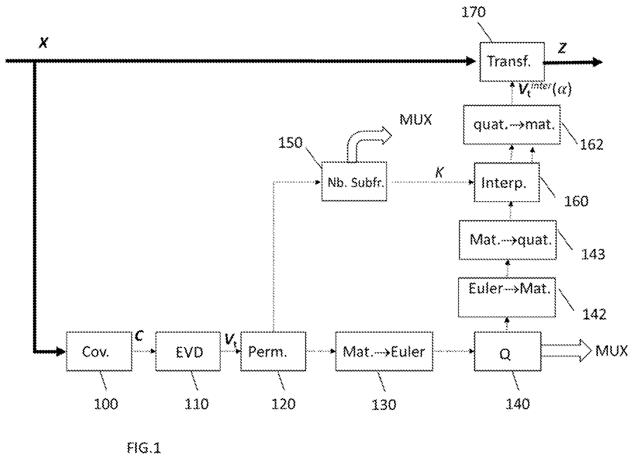

La figure 1 illustre le codage selon cette approche de l'état de l'art. Le codage se déroule en plusieurs étapes :

- Les signaux des canaux (par exemple W, Y, Z, X pour le cas FOA) sont supposés être sous une forme matricielle X avec une matrice n $\times$ L (pour n canaux ambisoniques (ici 4) et L échantillons par trame). On peut optionnellement pré-traiter ces canaux par exemple par un filtre passe-haut.
- On applique à ces signaux une analyse en composantes principales PCA ou de façon équivalente une transformée de Karhunen Loeve (KLT), avec estimation de matrice de covariance (bloc 100) et décomposition en valeurs propres notée EVD pour « *Eigen Value Decomposition* » en anglais (bloc 110), pour obtenir des valeurs propres et une matrice de vecteurs propres à partir d'une matrice de covariance des n signaux.
- La matrice de vecteurs propres, obtenue pour la trame courante t, subit des permutations signées (bloc 120) pour qu'elle soit la plus alignée possible avec la matrice de même nature de la trame précédente t - 1, afin d'assurer une cohérence maximale entre les matrices entre deux trames. On s'assure dans le bloc 120 en outre que la matrice de vecteurs propres de la trame courante t, ainsi corrigée par permutations signées, représente bien l'application d'une rotation.
- La matrice de vecteurs propres pour la trame courante t (qui est une matrice de rotation) est convertie dans un domaine approprié de paramètres de quantification (bloc 130). Dans un exemple de réalisation de la demande de brevet WO2020177981, les paramètres correspondent à 6 angles d'Euler généralisés pour une matrice 4x4 ; on aurait 3 angles d'Euler pour une matrice 3x3.

Puis ces paramètres sont codés (bloc 140) sur un nombre de bits alloués à la quantification de paramètres. Une quantification scalaire des angles d'Euler généralisés peut être par exemple utilisée, avec un pas de quantification identique pour chaque angle.

- Dans un exemple de réalisation de la demande de brevet WO2020177981, les paramètres décodés (sous la forme d'angles d'Euler généralisés) sont convertis en matrice de rotation (bloc 142), puis la matrice de rotation ainsi obtenue est convertie en quaternions (bloc 143). La trame courante est découpée en sous-trames, dont le nombre peut être fixe ou adaptatif - dans ce dernier cas, ce nombre peut être déterminé en fonction des informations issues de l'analyse PCA/KLT et il peut être transmis de façon optionnelle (bloc 150). La représentation par quaternion est interpolée (bloc 160) par sous-trames successives depuis la trame précédente $t$ - 1 jusqu'à la trame courante $t$, afin de lisser dans le temps la différence entre matriçage. Les quaternions interpolés dans chaque sous-trame sont convertis en matrices de rotation (bloc 162) puis on applique les matrices résultantes de rotation décodées et interpolées (bloc 170). Dans chaque trame, on obtient en sortie du bloc 170 une matrice $n \times (L/K)$ représentant chacune des $K$ sous-trames des signaux des canaux ambisoniques pour décorréler autant que possible ces signaux avant le codage (par exemple un codage multi-mono). Une allocation binaire aux canaux séparés est également effectuée.

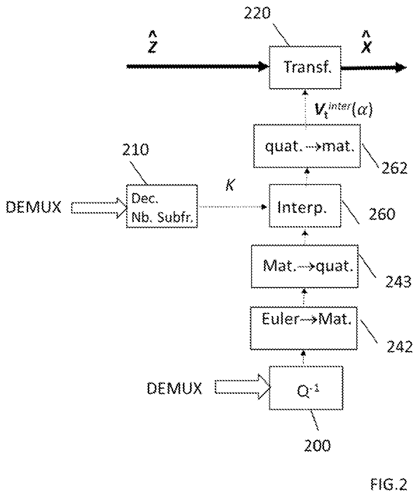

La figure 2 illustre le décodage correspondant.

Les indices de quantification des paramètres de quantification de la matrice de rotation dans la trame courante sont décodés dans le bloc 200. Les étapes de conversion et d'interpolation (blocs 242, 243, 260, 262) du décodeur sont identiques à celles effectuées à l'encodeur (blocs 142, 143, 160 et 162). Si le nombre de sous-trames d'interpolation est adaptatif, celui-ci est décodé (bloc 210) - autrement on fixe ce nombre de sous-trames d'interpolation à une valeur prédéterminée.

Le bloc 220 applique par sous-trame le matriçage inverse issu du bloc 262 aux signaux décodés des canaux ambisoniques , en rappelant que l'inverse d'une matrice de rotation est sa transposée .

Dans la demande de brevet précitée, la quantification des matrices de rotations 3x3 ou 4x4 est préférentiellement effectuée dans le domaine des angles d'Euler (cas 3x3) ou angles d'Euler généralisés (cas 4x4) et l'interpolation est effectuée dans le domaine des quaternions. Cela implique de multiples conversions entre matrice et paramètres différents, donc une complexité accrue car on utilise deux types différents de paramètres pour la quantification et l'interpolation. De plus, la conversion en angles d'Euler - en particulier pour les angles d'Euler généralisés selon la méthode décrite de l'article de Hoffman et al. - peut poser certains problèmes en pratique, car elle peut être numériquement 'instable', dans le sens où la combinaison de la conversion directe et inverse (de matrice à angles d'Euler suivie par la conversion inverse) peut ne pas redonner exactement la matrice originale (même en l'absence de quantification des angles) et la quantification peut induire des problèmes tels que le blocage de cardan (« gimbal lock » en anglais) qui consiste en la perte d'un degré de liberté, qui survient quand les axes de deux des trois cardans nécessaires pour appliquer ou compenser les rotations dans l'espace à trois dimensions sont portés par la même direction.; dans de tels cas, la décorrélation par PCA/KLT n'est plus optimale.

Il serait plus avantageux de ne recourir qu'à un seul type de paramètres pour le codage des matrices de rotations et leur interpolation, une conversion de la matrice de rotation peut être effectuée dans le domaine des quaternions et une quantification de paramètres issue de cette conversion peut être effectuée pour remplacer la quantification de paramètres tels que les angles d'Euler (généralisés ou non). Dans la littérature, on ne trouve pas de méthodes efficaces pour coder un quaternion ou un double quaternion avec la contrainte de représenter une matrice de rotation avec une précision similaire à la quantification d'angles d'Euler (généralisés ou non) et avec un budget de bits donné - par exemple autour de 25 bits/quaternion ou 50 bits/double quaternion.

Il existe donc un besoin d'optimiser cette quantification de paramètres en termes de débit et/ou de complexité et/ou de stockage d'informations.

L'invention vient améliorer l'état de la technique.

A cet effet, l'invention vise un procédé de codage d'un signal sonore multicanal, comportant une formation d'une matrice de transformation sous la forme d'une matrice de rotation à appliquer aux signaux d'entrée, une quantification de la matrice de rotation et un codage des signaux transformés après application de la matrice de rotation, dans lequel la quantification de la matrice de rotation comporte les opérations suivantes :

- convertir la matrice de rotation dans le domaine des quaternions avec au moins un premier quaternion ;
- forcer ledit premier quaternion à avoir une composante positive ;
- convertir le au moins un premier quaternion en coordonnées sphériques, une des coordonnées sphériques étant associée à la composante forcée positive du premier quaternion ;
- quantifier les coordonnées sphériques obtenues, la coordonnée sphérique associée à la composante forcée positive du premier quaternion étant quantifiée sur un intervalle de demi-longueur.

La quantification des quaternions pour coder la matrice de rotation permet d'éviter de multiples conversions puisque le domaine des quaternions est aussi utilisé pour effectuer une interpolation de la matrice de rotation avant l'application de cette matrice au signal multicanal.

Cette quantification est de plus optimisée pour restreindre le débit à utiliser en forçant un des paramètres d'un quaternion à être positif et ainsi ne coder que le quaternion concerné positif, le quaternion négatif correspondant à la même rotation. La conversion en coordonnées sphériques et la quantification de ces coordonnées sphériques permet d'utiliser une méthode de quantification qui ne nécessite pas l'utilisation de dictionnaires couteux à la fois en espace mémoire et en capacité de traitement. La quantification sur une moitié d'intervalle permet de plus de bénéficier d'un gain en débit.

Dans un mode particulier de réalisation, la composante positive dudit premier quaternion est sa composante réelle.

De façon simple, la composante réelle ($a_1$) du premier quaternion est choisi par convention.

Dans un mode de réalisation, la matrice de rotation est convertie en double quaternion, un premier quaternion pour lequel une composante est forcée à être positive et un deuxième quaternion.

Selon un mode de réalisation, la quantification du premier quaternion utilise un bit de moins que la quantification du deuxième quaternion. Le débit est ainsi optimisé.

Dans un mode de réalisation, la conversion en coordonnées sphériques de chacun des deux quaternions du double quaternion donne trois angles, et la quantification de l'angle associé à la composante positive du premier quaternion s'effectue selon un intervalle de demi-longueur par rapport à l'intervalle utilisé pour quantifier la même composante dans le deuxième quaternion.

L'obtention de ces angles obtenus pour chaque quaternion permet d'obtenir des paramètres moins complexes à quantifier. En effet, quantifier les angles ainsi obtenus plutôt que de quantifier le quaternion en question est moins complexe car elle ne nécessite pas nécessairement l'utilisation de dictionnaires couteux à la fois en espace mémoire et en capacité de traitement.

La prise en compte de la composante positive du premier quaternion permet d'effectuer une quantification sur un intervalle restreint sur ce quaternion, ce qui minimise le débit à allouer pour la quantification de ce quaternion.

Dans un mode particulier de réalisation de ce mode, la quantification des six angles obtenus s'effectue par quantification scalaire uniforme.

Cette méthode de quantification est simple et peu complexe.

Dans un autre mode particulier de réalisation, la quantification des six angles obtenus s'effectue par quantification vectorielle à support hyper-rectangulaire.

Cette méthode de quantification est une autre alternative simple et peu complexe. Dans un mode particulier de réalisation, une indication binaire est en outre codée pour indiquer si le au moins un premier quaternion prend des valeurs par défaut.

Les valeurs par défaut des quaternions peuvent être typiquement tels que q=(1,0,0,0,), ce qui indique que la matrice de transformation est une matrice identité. Dans ce cas, si l'indication binaire indique que les quaternions prennent ces valeurs par défaut, cela indique que la transformation est désactivée pour la trame courante.

L'invention se rapporte aussi à un procédé de décodage d'un signal sonore multicanal, comportant la réception de signaux codés issus d'un signal multicanal et comportant en outre les opérations :

- recevoir des paramètres de coordonnées sphériques quantifiés d'un ensemble d'au moins un premier quaternion et une indication d'existence d'une composante positive ;
- décoder le au moins un premier quaternion à partir des paramètres quantifiés reçus en prenant un intervalle de quantification de demi-longueur pour décoder une coordonnée sphérique associée à la composante positive indiquée ;
- construire une matrice de rotation inverse à partir du au moins un premier quaternion décodé;
- appliquer ladite matrice de rotation inverse aux signaux codés reçus, avant un décodage desdits signaux.

Ainsi, le décodeur peut recevoir et décoder un ensemble de quaternions qui permet de reconstruire une matrice de rotation utile pour décoder le signal multicanal.

L'obtention d'un indice de positivité d'une composante d'au moins un quaternion permet d'appliquer un décodage adapté, en ne décodant que le quaternion positif pour en déduire le quaternion négatif.

Cet ensemble de quaternions permet également son utilisation pour interpoler la matrice de rotation obtenue, sans avoir à effectuer d'autres conversions de cette matrice, afin d'obtenir une matrice interpolée applicable aux signaux du signal multicanal.

Le décodage de cet ensemble de quaternions peut s'effectuer avec une complexité moindre, notamment lorsque les paramètres codés sont des angles issus d'un double quaternion.

Une méthode de quantification scalaire inverse peut par exemple être mise en œuvre dans ce cas.

L'invention se rapporte également à un dispositif de codage comportant un circuit de traitement pour la mise en œuvre du procédé de codage tel que décrit précédemment. L'invention se rapporte également à un dispositif de décodage comportant un circuit de traitement pour la mise en œuvre du procédé de décodage tel que décrit précédemment. L'invention se rapporte à un programme informatique comportant des instructions pour la mise en œuvre des procédés de codage ou de décodage tels que décrits précédemment, lorsqu'ils sont exécutés par un processeur.

Enfin, l'invention se rapporte à un support de stockage, lisible par un processeur, mémorisant un programme informatique comportant des instructions pour l'exécution des procédés de codage ou de décodage décrits précédemment.

D'autres caractéristiques et avantages de l'invention apparaîtront plus clairement à la lecture de la description suivante de modes de réalisation particuliers, donnés à titre de simples exemples illustratifs et non limitatifs, et des dessins annexés, parmi lesquels :

[Fig 1] La figure 1 illustre un mode de réalisation d'un codeur et d'un procédé de codage selon une méthode de l'état de l'art ;

[Fig 2] La figure 2 illustre un mode de réalisation d'un décodeur et d'un procédé de décodage selon une méthode de l'état de l'art ;

[Fig 3] La figure 3 illustre un mode de réalisation d'un codeur et d'un procédé de codage selon l'invention ;

[Fig 4] La figure 4 illustre un mode de réalisation d'un décodeur et d'un procédé de décodage selon l'invention ;

[Fig 5a] La figure 5a illustre sous forme d'organigramme les étapes mises en œuvre par les blocs de conversion et de quantification lors du codage d'un signal audio multicanal selon un mode de réalisation de l'invention ;

[Fig 5b] La figure 5b illustre sous forme d'organigramme les étapes mises en œuvre lors de la quantification d'un double quaternion selon un mode de réalisation de l'invention ;

[Fig 5c] La figure 5c illustre sous forme d'organigramme les étapes mises en œuvre lors de la quantification d'un quaternion selon un premier mode de réalisation de l'invention ;

[Fig 5d] La figure 5d illustre sous forme d'organigramme les étapes mises en œuvre lors de la quantification des angles issus d'un quaternion selon un premier mode de réalisation de l'invention ;

[Fig 5e] La figure 5e illustre sous forme d'organigramme les étapes mises en œuvre lors d'une quantification d'un angle selon un mode particulier de réalisation de l'invention ;

[Fig 6a] La figure 6a illustre sous forme d'organigramme les étapes mises en œuvre lors de la quantification inverse d'un double quaternion lors du décodage d'un signal audio multicanal, selon un mode de réalisation de l'invention;

[Fig 6b] La figure 6b illustre sous forme d'organigramme les étapes mises en œuvre lors de la quantification inverse d'un angle définissant un quaternion, selon un mode de réalisation de l'invention ; et

[Fig 7] La figure 7 illustre des exemples de réalisation structurelle d'un codeur et d'un décodeur selon un mode de réalisation de l'invention.

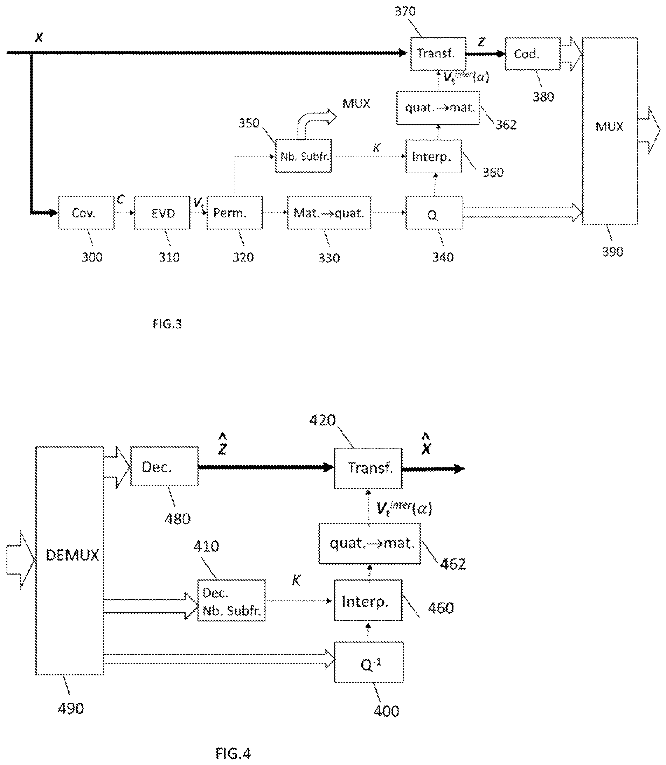

La figure 3 illustre un exemple de réalisation du procédé de codage et d'un codeur selon l'invention. Les blocs 300, 310 et 320 d'analyse KLT/PCA par trame sont, dans un exemple de réalisation, identiques aux blocs 100, 110 et 120 de la figure 1 précédemment décrite ; les blocs d'interpolation de quaternions 350, 360 sont identiques aux blocs 150 et 160 de la figure 1 et les blocs de conversion inverse 362 et de matriçage 370 sont identiques aux blocs 162 et 170 de la figure 1. Cependant l'invention s'applique aux cas où une mise en œuvre différente est utilisée pour chacun de ces blocs.

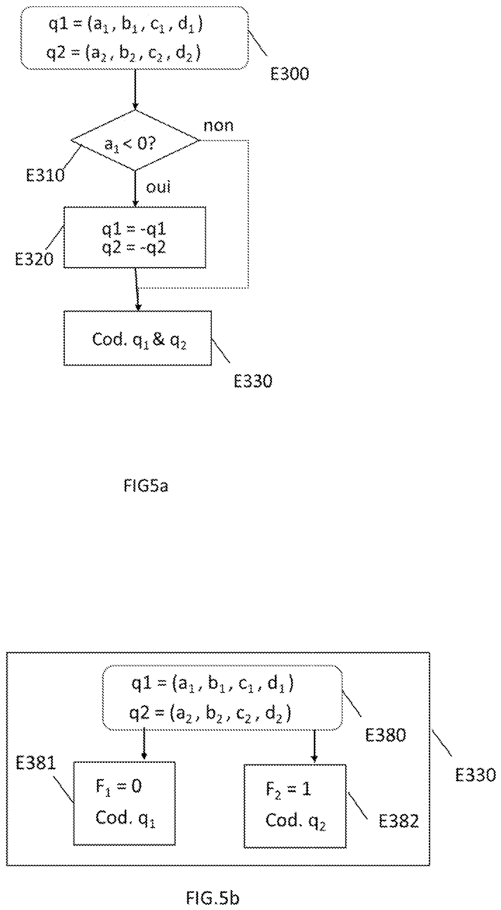

Une description plus détaillée de ces blocs peut être retrouvée dans la demande de brevet citée précédemment. On a rajouté ici explicitement le bloc de codage des signaux transformés (bloc 380) qui peut être un codage multi-mono ou tout autre type de codage multicanal, et le bloc de multiplexage (bloc 390) qui forme le train binaire ou la charge utile d'un paquet de données codées. La différence avec la figure 1 réside notamment dans la conversion en quaternion (bloc 330) suivie d'une quantification optimisée (bloc 340) qui est décrite ultérieurement en référence aux figures 5a à 5e, et dans le multiplexage (bloc 390).

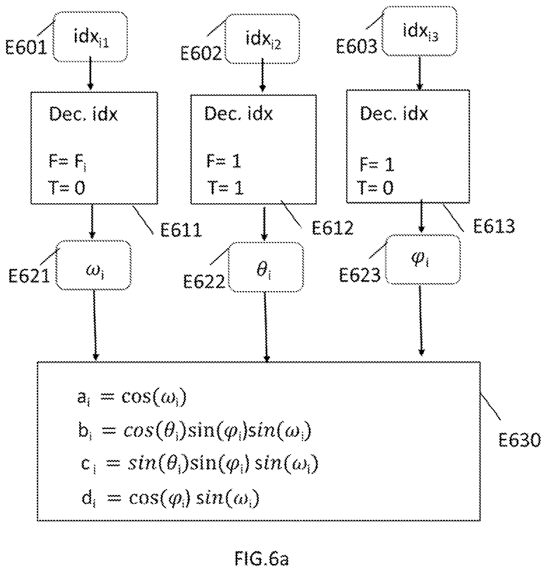

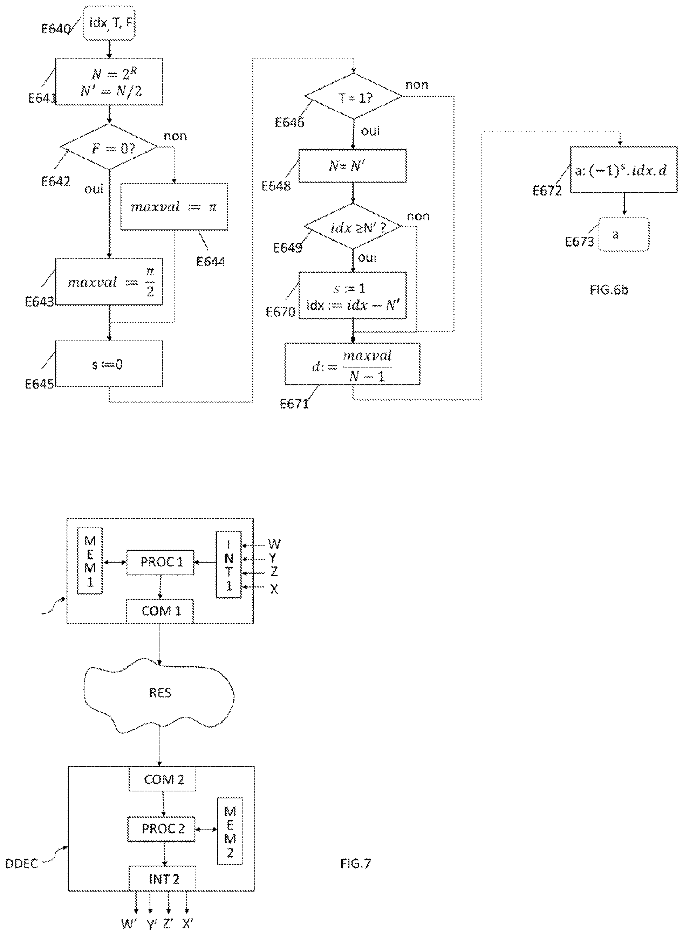

La figure 4 illustre le décodage correspondant. Là encore, on retrouve les blocs d'interpolation de quaternions (blocs 410 et 460) identiques aux blocs 210 et 260 de la figure 2, le bloc de conversion inverse 462 identique au bloc 262 de la figure 2 et le bloc de matriçage 420, identique au bloc 220 de la figure 2. Là aussi, on a rajouté explicitement les blocs de décodage des signaux transformés (bloc 480) et le bloc de démultiplexage 490. L'invention réside ici dans le décodage optimisé de quaternions dans le bloc 400 décrit ultérieurement en référence aux figures 6a et 6b, et dans le démultiplexage (bloc 490).

On rappelle ici certains concepts explicatifs concernant les rotations en dimension n et leur conversion en quaternion dans le cas 3x3 et double quaternion dans le cas 4x4. Comme décrit dans la demande de brevet citée précédemment, la méthode de codage utilise une représentation des rotations en dimension n=3 ou 4 avec des paramètres adaptés pour une quantification par trame et une interpolation efficace par sous-trame. On définit ci-dessous certaines représentations de rotations qui peuvent être utilisées en dimension 3 et 4, et on se focalise sur la dimension 4 dans le mode de réalisation privilégié.

Une rotation (autour de l'origine) est une transformation de l'espace en dimension n qui modifie un vecteur en un autre vecteur, telle que :

- L'amplitude du vecteur est préservée ;
- Le produit vectoriel de vecteurs définissant un repère orthonormé avant rotation est préservé après rotation (il n'y a pas de réflexion).

Une matrice $M$ de taille $n \times n$ est une matrice de rotation si et seulement si $M^T M = I_n$ où $I_n$ désigne la matrice identité de taille $n \times n$ (c'est-à-dire que $M$ est une matrice unitaire, $M^T$ désignant la transposée de $M$) et son déterminant vaut +1. On note au passage que l'inverse de $M$ est sa transposée.

Il existe plusieurs représentations équivalentes à la représentation par matrice de rotation.

Dans l'espace en trois dimensions (3D) (n = 3): On utilise souvent comme représentation d'une rotation 3D les angles d'Euler, les quaternions (unitaires), ou encore une représentation par axe-angle - cette dernière n'est pas décrite ici. La représentation en 3 angles d'Euler dérive du fait qu'une matrice de rotation de taille 3x3 peut être décomposée en un produit de 3 matrices de rotation élémentaire ; les matrices de rotation élémentaire d'angle θ selon les axes *x, y,* ou *z* sont données ci-dessous :

$$M_{3,x}(\theta) = \begin{pmatrix} 1 & 0 & 0 \\ 0 & \cos\theta & -\sin\theta \\ 0 & \sin\theta & \cos\theta \end{pmatrix}$$

$$M_{3,y}(\theta) = \begin{pmatrix} \cos\theta & 0 & \sin\theta \\ 0 & 1 & 0 \\ -\sin\theta & 0 & \cos\theta \end{pmatrix}$$

$$M_{3,z}(\theta) = \begin{pmatrix} \cos\theta & -\sin\theta & 0 \\ \sin\theta & \cos\theta & 0 \\ 0 & 0 & 1 \end{pmatrix}$$

Selon les combinaisons d'axes et selon que les axes sont définis en absolu ou relatif, les angles sont dits d'Euler ou de Cardan.

Une rotation 3D peut aussi être représentée par un quaternion. Les quaternions sont une généralisation des nombres complexes avec quatre composantes sous la forme d'un nombre $q = a + bi + cj + dk$ où $i^2 = j^2 = k^2 = ijk = -1$.

La partie réelle *a* est appelée scalaire et les trois parties imaginaires (*b, c, d*) forment un vecteur 3D. La norme d'un quaternion est $|q| = \sqrt{a^2 + b^2 + c^2 + d^2}$. Les quaternions unitaires (de norme 1) représentent les rotations - cependant cette représentation n'est pas unique ; ainsi, si **q** représente une rotation, **-q** représente la même rotation. Dans la suite, le terme de quaternion est à prendre au sens de quaternion unitaire, et le qualificatif « unitaire » n'est pas systématiquement repris - sauf pour des rappels ponctuels - pour ne pas alourdir le texte.

On notera que dans la littérature le quaternion $q = a + bi + cj + dk$ est en général vu comme un vecteur (*a, b, c, d*) de dimension 4; parfois la partie réelle est permutée en (*b, c, d, a*) - on suppose par la suite, sans perte de généralité, la convention sur l'ordre des éléments sous la forme (*a, b, c, d*). Par la suite, on appellera *composante* d'un quaternion chacun des éléments *a, b, c, d*. Ainsi, *a* est aussi désignée par la suite comme la composante réelle de **q.**

Etant donné un quaternion unitaire $q = a + bi + cj + dk$ (avec $a^2 + b^2 + c^2 + d^2 = 1$), la matrice de rotation 3D associée est :

$$M_{3,quat}(q) = \begin{pmatrix} a^2 + b^2 - c^2 - d^2 & 2(bc - ad) & 2(ac + bd) \\ 2(ad + bc) & a^2 - b^2 + c^2 - d^2 & 2(cd - ab) \\ 2(bd - ac) & 2(ab + cd) & a^2 - b^2 - c^2 + d^2 \end{pmatrix}$$

Inversement, pour une matrice de rotation 3x3, on peut déterminer un quaternion associé (au signe près) ; en effet, **q** et **-q** représentent la même matrice $M_{3,quat}(q) = M_{3,quat}(-q)$. Une méthode de conversion de $M_{3,quat}(q)$ à $\pm q$ est décrite plus loin en rapport avec le bloc 330.

Les angles d'Euler ne permettent pas d'interpoler correctement des rotations 3D ; pour ce faire on utilise plutôt les quaternions. La méthode d'interpolation SLERP (pour « spherical linear interpolation ») consiste à interpoler selon la formule :

$$slerp(\boldsymbol{q}_1, \boldsymbol{q}_2, \alpha) = \frac{\sin(1-\alpha)\Omega}{\sin\Omega}\boldsymbol{q}_1 + \frac{\sin\alpha\Omega}{\sin\Omega}\boldsymbol{q}_2$$

où $0 \leq \alpha \leq 1$ est le facteur d'interpolation pour aller de $\boldsymbol{q}_1$ à $\boldsymbol{q}_2$ et $\Omega$ est l'angle entre les deux quaternions:

$$\Omega = \arccos(\boldsymbol{q}_1.\boldsymbol{q}_2)$$

où $\boldsymbol{q}_1.\boldsymbol{q}_2$ désigne le produit scalaire entre deux quaternions (identique au produit scalaire entre deux vecteurs de dimension 4). Cela revient à interpoler en suivant un grand cercle sur une sphère 4D avec une vitesse angulaire constante en fonction de $\alpha$. Il convient de s'assurer que le plus court chemin est utilisé pour l'interpolant en changeant le signe de l'un des quaternions quand $\boldsymbol{q}_1.\boldsymbol{q}_2 < \mathbf{0}$. On notera que d'autres méthodes d'interpolation de quaternions peuvent être utilisées (NLERP pour « normalized linear interpolation » qui revient à interpoler sur une corde et à renormaliser le résultat, splines, etc.).

En dimension 4 (n = 4), une rotation peut être paramétrée par $\frac{n(n-1)}{2} = 6$ angles d'Euler généralisés comme indiqué dans la demande de brevet citée précédemment.

On s'intéresse ici à la représentation par double quaternion. Cette représentation nécessite de recourir à la forme matricielle d'un quaternion.

On définit les matrices de taille 4x4, appelées ici quaternion (**Q**) et antiquaternion ($\boldsymbol{Q}^{\star}$), associées à un quaternion (unitaire) $\boldsymbol{q} = a + bi + cj + dk$ par:

$$\boldsymbol{Q} = \begin{pmatrix} a & -b & -c & -d \\ b & a & -d & c \\ c & d & a & -b \\ d & -c & b & a \end{pmatrix}$$

Et

$$\boldsymbol{Q}^{\star} = \begin{pmatrix} a & -b & -c & -d \\ b & a & d & -c \\ c & -d & a & b \\ d & c & -b & a \end{pmatrix}$$

ce qui correspond à la « convention colonne », car un quaternion est alors représenté comme un *vecteur 4D colonne.* Les matrices **Q** et **Q\*** correspondent respectivement à une multiplication à gauche par **q** et une multiplication à droite par **q** .

On peut vérifier que le produit des deux quaternions $\boldsymbol{q_1}\boldsymbol{q_2}$ est obtenu de façon équivalente sous la forme matricielle:

$$\boldsymbol{q_1}\boldsymbol{q_2} = \boldsymbol{Q}_1 \begin{pmatrix} a_2 \\ b_2 \\ c_2 \\ d_2 \end{pmatrix} = \boldsymbol{Q}_2^{\star} \begin{pmatrix} a_1 \\ b_1 \\ c_1 \\ d_1 \end{pmatrix}$$

où, pour les quaternions $\boldsymbol{q}_1 = a_1 + b_1 i + c_1 j + d_1 k$ et $\boldsymbol{q}_2 = a_2 + b_2 i + c_2 j + d_2 k,$ avec :

$$\boldsymbol{Q}_1 = \begin{pmatrix} a_1 & -b_1 & -c_1 & -d_1 \\ b_1 & a_1 & -d_1 & c_1 \\ c_1 & d_1 & a_1 & -b_1 \\ d_1 & -c_1 & b_1 & a_1 \end{pmatrix}$$

Et

$$Q_2^\star = \begin{pmatrix} a_2 & -b_2 & -c_2 & -d_2 \\ b_2 & a_2 & d_2 & -c_2 \\ c_2 & -d_2 & a_2 & b_2 \\ d_2 & c_2 & -b_2 & a_2 \end{pmatrix}$$

Etant donnés deux quaternions unitaires $q_1$ et $q_2$, le produit de $Q_1$ et $Q_2^\star$ donne une matrice de taille 4x4 qui vérifie les propriétés d'une matrice de rotation (matrice unitaire et déterminant égal à 1) :

$$M_{4,quat}(q_1, q_2) = Q_1 Q_2^\star$$

On notera que $M_{4,quat}(q_1, q_2) = M_{4,quat}(q_2, q_1)$

Inversement, étant donné une matrice de rotation 4x4, il est possible de retrouver un double quaternion associé $(q_1, q_2)$ et les matrices de quaternion et antiquaternion correspondantes. Autrement dit, on peut factoriser cette matrice en un produit de matrices sous la forme $Q_1 Q_2^\star$, par exemple avec la méthode dite «factorisation de Cayley». Cela implique en général de calculer une matrice intermédiaire appelée « matrice associée » (ou «transformée tétragonale») et d'en déduire les quaternions à une indétermination près sur le signe des deux quaternions. On note que $M_{4,quat}(q_1, q_2) = M_{4,quat}(-q_1, -q_2)$ ; cette propriété est utilisée dans le cadre de l'invention pour coder plus efficacement les quaternions.

Dans des variantes, la définition des matrices de quaternion et antiquaternion pourra prendre des conventions différentes. Par exemple :

- convention ligne :

$$Q = \begin{pmatrix} a & b & c & d \\ -b & a & -d & c \\ -c & d & a & -b \\ -d & -c & b & a \end{pmatrix}$$

Et

$$Q^\star = \begin{pmatrix} a & -b & -c & -d \\ b & a & -d & c \\ c & d & a & -b \\ d & -c & b & a \end{pmatrix}$$

- convention de l'article qui permute certaines composantes et change certains signes:

$$Q_1 = \begin{pmatrix} a_1 & -d_1 & c_1 & -b_1 \\ d_1 & a_1 & -b_1 & -c_1 \\ -c_1 & b_1 & a_1 & -d_1 \\ b_1 & c_1 & d_1 & a_1 \end{pmatrix}$$

Et

$$Q_2^\star = \begin{pmatrix} a_2 & -d_2 & c_2 & b_2 \\ d_2 & a_2 & -b_2 & c_2 \\ -c_2 & b_2 & a_2 & d_2 \\ -b_2 & -c_2 & -d_2 & a_2 \end{pmatrix}$$

D'une manière générale il est possible d'intercaler une matrice de permutation signée dans la factorisation de Cayley et l'invention s'applique dans tous ces cas de figures. Pour simplifier et sans perte de généralité on ne décrit par la suite qu'un exemple de convention (la « convention colonne » décrite précédemment) en sortie du bloc 330 qui permet d'obtenir un double quaternion $(q_1, q_2)$ sous la forme de deux vecteurs 4D à coder.

Ces conventions alternatives ont un impact sur le bloc 330 de conversion de matrice à double quaternion (en particulier sur le calcul de la « matrice associée ») et sur le bloc inverse 362 et 462 qui calcule (explicitement ou de façon optimisée) le produit de matrices sous la forme $Q_1 Q_2^\star$. L'homme de l'art saura adapter ce calcul en fonction de la convention adoptée.

Les cas 3x3 et 4x4 sont reliés par le fait qu'une rotation 3D peut être vue comme une rotation 4x4 avec la contrainte : $q_1 = q$ et $q_2 = -q$. Dans ce cas, $M_{4,quat}(q,-q) = Q Q^\star = \begin{pmatrix} 1 & 0 \\ 0 & M_{3,quat}(q) \end{pmatrix}$

Comme pour le cas 4x4, pour simplifier et sans perte de généralité on ne décrit par la suite qu'un exemple de convention (la « convention colonne » décrite précédemment).

Comme décrit en référence à la figure 3 l'invention se rapporte à un codeur et un procédé de codage, dans lequel les blocs 330 et 340 mettent en œuvre une conversion de la matrice de rotation issue d'une analyse KLT/PCA et une quantification des paramètres de cette matrice de façon optimisée.

L'invention permet d'éviter qu'une représentation différente de celle utilisée dans le bloc 360 pour l'interpolation soit obtenue.

Selon l'invention il est donc choisi préférentiellement de quantifier les matrices de dimension 3 et 4 dans le domaine des quaternions et doubles quaternions (respectivement), ce qui permet de rester dans le même domaine pour la quantification et l'interpolation.

On s'intéresse plus particulièrement au cas d'une matrice de dimension 4 dans le mode de réalisation décrit à présent.

L'analyse PCA/KLT et la transformation PCA/KLT telles que décrites dans la demande de brevet WO2020177981 sont effectuées dans le domaine temporel. Cependant, l'invention s'applique également au cas où une analyse PCA/KLT est effectuée par exemple dans un domaine fréquentiel avec une estimation d'une matrice de covariance (réelle) par sous-bandes.

La méthode de codage selon l'invention met en œuvre les étapes décrites en référence à la figure 3. Le bloc 330 convertit la matrice de rotation en double quaternion pour le cas 4D.

Cette conversion pourra être réalisée comme suit pour une matrice de rotation $M_{4,quat}(q_1,q_2)$ notée ici $M = (m_{ij})_{i,j=0,...,3}$ pour simplifier les développements :

On cherche à factoriser $M$ sous la forme $M = Q_1 Q_2^\star$ ;

$$Q_1 = \begin{pmatrix} a_1 & b_1 & c_1 & d_1 \\ -b_1 & a_1 & -d_1 & c_1 \\ -c_1 & d_1 & a_1 & -b_1 \\ -d_1 & -c_1 & b_1 & a_1 \end{pmatrix}$$

Et

$$Q_2^\star = \begin{pmatrix} a_2 & -b_2 & -c_2 & -d_2 \\ b_2 & a_2 & -d_2 & c_2 \\ c_2 & d_2 & a_2 & -b_2 \\ d_2 & -c_2 & b_2 & a_2 \end{pmatrix}$$

On peut montrer que cette factorisation est équivalente à résoudre:

$$\begin{pmatrix} a_1 a_2 & a_1 b_2 & a_1 c_2 & a_1 d_2 \\ b_1 a_2 & b_1 b_2 & b_1 c_2 & b_1 d_2 \\ c_1 a_2 & c_1 b_2 & c_1 c_2 & c_1 d_2 \\ d_1 a_2 & d_1 b_2 & d_1 c_2 & d_1 d_2 \end{pmatrix} = U$$

où $u$ est la « matrice associée » de $M$ obtenue à partir des coefficients $m_{ij}$ de $M$ comme suit:

$$U =$$

$$\frac{1}{4}\begin{pmatrix} m_{00} + m_{11} + m_{22} + m_{33} & m_{10} - m_{01} - m_{32} + m_{23} & m_{20} + m_{31} - m_{02} - m_{13} & m_{30} - m_{21} + m_{12} - m_{03} \\ m_{10} - m_{01} + m_{32} - m_{23} & -m_{00} - m_{11} + m_{22} + m_{33} & m_{30} - m_{21} - m_{12} + m_{03} & -m_{20} - m_{31} - m_{02} - m_{13} \\ m_{20} - m_{31} - m_{02} + m_{13} & -m_{30} - m_{21} - m_{12} - m_{03} & -m_{00} + m_{11} - m_{22} + ml_{33} & m_{10} + m_{01} - m_{32} - m_{23} \\ m_{30} + m_{21} - m_{12} - m_{03} & m_{20} - m_{31} - m_{02} - m_{13} & -m_{10} - m_{01} - m_{32} - m_{23} & -m_{00} + m_{11} + m_{22} + m_{33} \end{pmatrix}$$

Etant donnés les coefficients $U = (u_{ij})_{ij=0,\ldots,3'}$, on trouve ligne par ligne, après mise au carré et sommation de tous les coefficients par ligne :

$$a_1{}^2\left(a_2{}^2 + b_2{}^2 + c_2{}^2 + d_2{}^2\right) = \sum_{j=0}^{3} u_{0j}^2$$

$$b_1{}^2\left(a_2{}^2 + b_2{}^2 + c_2{}^2 + d_2{}^2\right) = \sum_{j=0}^{3} u_{1j}^2$$

$$c_1{}^2\left(a_2{}^2 + b_2{}^2 + c_2{}^2 + d_2{}^2\right) = \sum_{j=0}^{3} u_{2j}^2$$

$$d_1{}^2\left(a_2{}^2 + b_2{}^2 + c_2{}^2 + d_2{}^2\right) = \sum_{j=0}^{3} u_{3j}^2$$

Ce qui donne, comme le quaternion $q_2$ est unitaire (c'est-à-dire $a_2{}^2 + b_2{}^2 + c_2{}^2 + d_2{}^2 = 1$) :

$$a_1 = sign(u_{0k})\sqrt{\sum_{j=0}^{3} u_{0j}^2}$$

$$b_1 = sign(u_{1k})\sqrt{\sum_{j=0}^{3} u_{1j}^2}$$

$$c_1 = sign(u_{2k})\sqrt{\sum_{j=0}^{3} u_{2j}^2}$$

$$d_1 = sign(u_{3k})\sqrt{\sum_{j=0}^{3} u_{3j}^2}$$

Par convention, le signe des composantes $a_1, b_1, c_1, d_1$ est donné respectivement par le signe de $u_{0k}, u_{1k}, u_{2k}, u_{3k}$ où k est choisi sur l'intervalle 0, ..,3. On notera que la factorisation a deux solutions possibles, car la convention opposée serait également une solution.

En choisissant la composante de valeur absolue maximale (garantie non nulle car le quaternion $q_1$ est unitaire) parmi $a_1, b_1, c_1, d_1$, par exemple et sans perte de généralité $a_1 \neq 0$, on déduit :

$$(a_2, b_2, c_2, d_2) = \frac{1}{a_1}(u_{00}, u_{01}, u_{02}, u_{03})$$

(si une autre composante que $a_1$ est sélectionnée, par exemple $b_1$, on aurait $\frac{1}{b_1}(u_{10}, u_{11}, u_{12}, u_{13})$ ).

On obtient donc en sortie du bloc 330 deux vecteurs 4D $(a_1, b_1, c_1, d_1)$ et $(a_2, b_2, c_2, d_2)$ représentant le double quaternion $(q_1, q_2)$.

La conversion en quaternion pour le cas 3D peut être réalisée comme suit pour une matrice $M_{3,quat}(q)$ notée $M = (a_{ij})_{i,j=0,..,2}$. On réutilise le cas 4x4 en partant de la matrice de rotation étendue :

$$M_{4,quat}(q, -q) = QQ^* = \begin{pmatrix} 1 & 0 \\ 0 & M_{3,quat}(q) \end{pmatrix}$$

La matrice associée se simplifie en :

$$U = $$

$$\frac{1}{4}\begin{pmatrix} m_{00}+m_{11}+m_{22}+a_{33} & -m_{21}+m_{12} & m_{20}-m_{02} & -m_{10}+m_{01} \\ m_{21}-m_{12} & -1-m_{00}+m_{11}+m_{22} & -m_{10}-m_{01} & -m_{20}-m_{02} \\ -m_{20}+m_{02} & -m_{10}-m_{01} & -1+m_{00}-m_{11}+m_{22} & -m_{21}-m_{12} \\ m_{10}-m_{01} & -m_{20}-m_{02} & -m_{21}-m_{12} & -1+m_{00}+m_{11}-m_{22} \end{pmatrix}$$

Le reste de la méthode de factorisation reste identique, sauf qu'il suffit de ne déterminer qu'un seul quaternion, par exemple, $q_1$, l'autre $(q_2)$ étant opposé - on détermine donc $a_1, b_1, c_1, d_1$ par racine carrée de sommes partielles de termes au carré de $U$, avec une détermination de signe selon la convention désignée.

On obtient donc en sortie du bloc 330 un vecteur 3D $(a_1, b_1, c_1, d_1)$ représentant le quaternion $q_1 = q$.

Selon l'invention, le bloc 340 réalise le codage des quaternions obtenus, dans le mode de réalisation décrit ici, d'un double quaternion pour le cas 4x4.

On se réfère maintenant à la figure 5a pour décrire, selon un mode de réalisation de l'invention, cette opération de quantification du double quaternion obtenu.

En référence à la figure 5a, étant donnés deux quaternions unitaires $q_i = (a_i, b_i, c_i, d_i)$, i = 1, 2, obtenus par le bloc de conversion 330, à l'étape E300, une opération consistant à forcer un premier quaternion, par exemple $q_1$, dans le double quaternion $(q_1, q_2)$ à avoir une composante positive est effectuée en E310 et E320. Dans un mode de réalisation particulier, c'est la composante réelle $(a_1)$ du premier quaternion que l'on force à être positive, par convention.

Pour ce faire on vérifie en E310 si la composante réelle $a_i$ est négative. Si c'est le cas, on remplace, en E320, les deux quaternions $q_1$ et $q_2$ par leurs opposés $-q_1$ et $-q_2$. On rappelle que cette opération ne change pas la matrice de rotation 4D associée au double quaternion.

Ces deux quaternions sont ensuite codés par quantification à l'étape E330.

Dans un premier mode de réalisation, afin de minimiser la complexité, on quantifie en E330, $q_1$ et $q_2$ par le dispositif de quantification représenté par le bloc 340 de la figure 3 et par une méthode telle que décrite en référence à la figure 5b décrite à présent.

Etant donné en E380 deux quaternions unitaires $q_i = (a_i, b_i, c_i, d_i)$, i = 1, 2 avec un premier quaternion $q_1$ pour lequel une composante a été forcée positive. Pour ce quaternion, une indication d'absence de composante positive (notée $F_1$) est mise à la valeur 0 (puisqu'une composante positive existe bien). Cette indication est mise à la valeur 1 ($F_2=1$) pour le deuxième quaternion $q_2$. Le paramètre F (pour « Full range » en anglais) permet de distinguer les intervalles [0, $\pi/2$] (F=0) et [0, $\pi$] (F=1).

Une étape de codage du premier quaternion $q_1$ est effectuée E381 (Cod. $q_1$) en prenant en compte l'indication d'absence de composante positive $F_1=0$ donnée pour $q_1$ et une étape de codage du deuxième quaternion $q_2$ est effectuée E382 (Cod. $q_2$) en prenant en compte l'indication d'absence de composante positive $F_2=1$ donnée pour $q_2$.

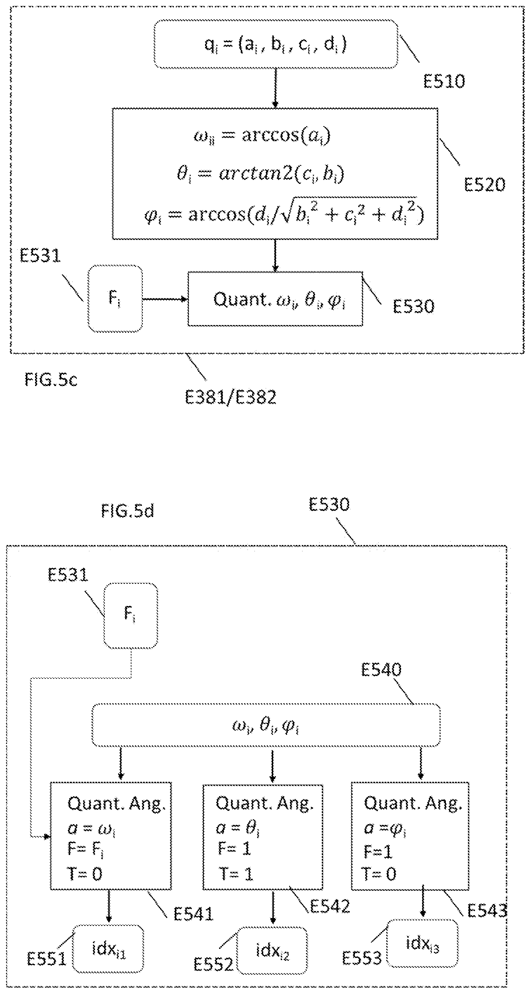

Ces deux étapes sont détaillées maintenant en référence à la figure 5c, dans un mode particulier de réalisation.

A partir d'un quaternion unitaire $q_i = (a_i, b_i, c_i, d_i)$, en E510, ce quaternion est converti en E520 en trois angles $(\omega_i, \theta_i, \varphi_i)$, qui sont assimilables à des coordonnées sphériques. Ces trois angles sont définis de la façon suivante pour un quaternion $q_i$:

$$\omega_i = \arccos(a_i)$$

$$\theta_i = arctan2(c_i, b_i)$$

$$\varphi_i = \arccos\left(\frac{d_i}{\sqrt{b_i^2 + c_i^2 + d_i^2}}\right)$$

où arccos est la fonction arc cosinus (à valeur entre [0, π]) et *arctan*2 est l'arc tangente sur les 4 quadrants pour obtenir un angle sur [-π, π]. Dans des variantes, d'autres définitions des angles $\omega_i$, $\theta_i$ ou $\varphi_i$ pourront être adoptées (par exemple à partir d'une fonction arc sinus notée arcsin ); dans ce cas, la quantification doit prendre en compte un intervalle différent (ex : [-π/2, π/2] au lieu de [0, π]) et les formules données ci-dessus pour la détermination des 3 angles doivent aussi être adaptées en conséquence (comme la conversion inverse).

Les trois angles $\omega_i$, $\theta_i$ et $\varphi_i$ tels que définis ci-dessus ont des valeurs sur l'intervalle [0, π], [-π, π] et [0, π] respectivement.

Dans le but de réduire au maximum la complexité, on quantifie en E530 les trois angles, par exemple par quantification scalaire uniforme, en prenant en compte l'indice $F_i$ tel que défini ci-dessus, donné en E531, pour un quaternion $q_i$.

La figure 5d décrit à présent les étapes mises en œuvre en E530 pour quantifier ces 3 angles.

Etant donné en E540 les trois angles $\omega_i$, $\theta_i$ et $\varphi_i$, et en E531 l'indication Fi, ces angles sont quantifiés respectivement en E541, E542 et E543 pour obtenir trois indices de quantification ($idx_{i1}$, $idx_{i2}$, $idx_{i3}$) en E551, E552 et E553, pour un quaternion $q_i$.

Pour cela, un paramètre F (pour « Full range » en anglais) définissant la largeur de l'intervalle de quantification et T (pour « two sided » en anglais) définissant l'existence de valeurs positives et négatives dans l'intervalle sont définis pour chacun des angles.

Pour le cas de l'angle $\omega_i$, la valeur de F correspond à la valeur de $F_i$, c'est-à-dire l'indication d'absence de composante positive. Dans le cas d'un premier quaternion pour lequel la valeur d'une composante a été forcée positive, cette valeur sera de 0, c'est-à-dire que la largeur de l'intervalle de quantification sera réduite à un demi-intervalle.

A l'inverse pour un deuxième quaternion, dont la valeur de $F_i$ est à 1, tout l'intervalle de quantification est utilisé (F=1).

Pour le cas de l'angle $\omega_i$, la valeur de T est mise à 0, c'est-à-dire que l'intervalle de quantification ne comprend pas de valeurs négatives. En effet, l'intervalle de quantification est [0, π/2] ou [0, π] pour cet angle.

Pour le cas de l'angle $\theta_i$, l'intervalle de quantification est [-π, π]. La valeur de F est définie à 1 et celle de T à 1.

Pour le cas de l'angle $\varphi_i$, l'intervalle de quantification est [0, π]. La valeur de F est définie à 1 et celle de T à 0.

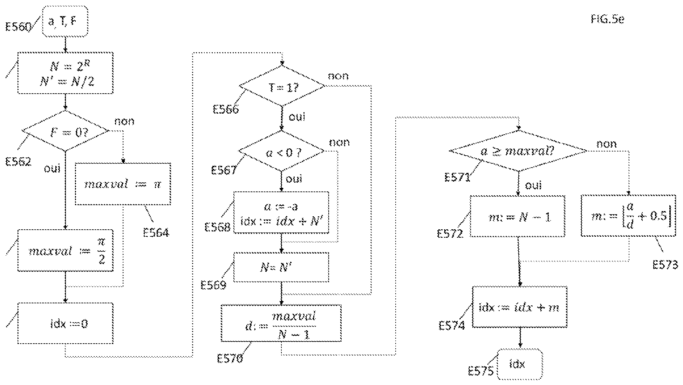

L'étape de quantification d'un angle noté $a$ de façon générique, telle que l'étape E541, E542 ou E543 est maintenant détaillée dans l'organigramme de la figure 5e.

En partant, en E560, des valeurs respectives de $a$ (valeur de l'angle $\omega_i$, $\theta_i$ et $\varphi_i$), T et F telles que définies ci-dessus, les paramètres N et N' sont définis en E561.

N= $2^R$ et N'=N/2 où R est le nombre de bits fixé par exemple à 8 bits.

En E562, on vérifie la valeur de F. Si F=0, la largeur de l'intervalle de quantification est réduite de moitié et a donc pour valeur maximale (*maxval*) de π/2 en E563. Dans le cas contraire, si F=1, l'intervalle de quantification n'est pas réduit et sa valeur maximale (*maxval*) est de π.

En E565, la valeur de l'indice de quantification idx est initialisée à la valeur 0.

En E566, on vérifie la valeur de T. Si T est égal à 1, on vérifie à l'étape E567 si la valeur de a est négative. Dans l'affirmative, on prend la valeur absolue de la valeur de l'angle a en E568 et on ajoute un offset (N') à l'indice de quantification.

On met à jour la valeur de N en E569 (N=N') pour indiquer que la moitié des indices de quantification est réservée pour les valeurs positives.

Dans le cas où a est positif en E567, on passe directement à l'étape E569.

En E570, un pas de quantification d est défini comme étant la valeur maximale (*maxval*) de l'intervalle sur *N* - 1.

Dans le cas où T est égal à 0 en E566, on passe directement à l'étape E570.

En E571, on vérifie la valeur de $a$ en la comparant à la valeur maximale de l'intervalle. Dans le cas où $a$ est supérieur à cette valeur maximale (*maxval*), l'étape E572 définie comme valeur quantifiée $m = N - 1$, dans le cas contraire, cette valeur quantifiée est définie à une valeur arrondie : $m = \left\lfloor \frac{a}{d} + 0.5 \right\rfloor$ En E574, la valeur de l'indice de quantification est mise à jour avec cette valeur quantifiée m.

On obtient ainsi la valeur de quantification idx de l'angle codé en E575 qui pourra être transmis vers un décodeur. Dans des variantes, d'autres formes de quantification scalaire pourront être mises en oeuvre (ex : autres pas de quantification, seuils de décision ou niveaux de reconstruction) et l'allocation binaire R pourra être différente de 8 bits pour chacun des angles $\omega_i$, $\theta_i$ et $\varphi_i$ afin d'avoir un budget de bits spécifique pour chacun des angles.

On notera que selon l'invention, le codage de $q_1$ requiert un bit de moins que le codage de $q_2$, car on exploite la contrainte $a_1 \geq 0$ en définissant $\omega_1$ sur $[0, \pi/2]$ au lieu de $[0, \pi]$. En effet, pour le cas d'une quantification scalaire uniforme sur R bits (par exemple R=8 bits), avec $N = 2^R$ valeurs de quantification (ou niveaux de reconstruction), si le pas de quantification $d$ est fixé à $d = (\pi/2)/(N - 1)$ pour couvrir l'intervalle de mi-longueur allant de 0 à $\pi/2$ (inclusivement) avec $N - 1$ sous-intervalles, on aura besoin de $N - 2$ sous-intervalles supplémentaires de même largeur $d$ pour couvrir l'intervalle complet allant de 0 à $\pi$, ce qui requiert 1 bit de plus. Pour ne pas laisser une valeur non utilisé, on peut aussi adapter légèrement le pas à $d' = \pi/(N - 1)$ où $N = 2^{R+1}$. Pour R=8 bits, la différence $d - d'$ est négligeable, elle est de $(\pi/2)/255 - \pi/511$, de l'ordre de 0.0007 degrés.

Ainsi, pour le codage de $q_1$, on utilise 8 bits pour $\omega_1$, 9 bits pour $\theta_1$ et 8 bits pour $\varphi_1$, soit 25 bits. Pour le codage de $q_2$, on utilise 9 bits pour $\omega_2$, 9 bits pour $\theta_2$, 8 bits pour $\varphi_2$, soit 26 bits. Au total, le budget utilisé est donc de 51 bits. Les rôles de $q_1$ et $q_2$ peuvent bien évidemment être intervertis pour forcer une composante à être positive et pour la quantification.

Le procédé de codage tel que décrit pour la figure 3 comporte une étape d'interpolation effectuée par le bloc 360 qui est calculée pour les deux quaternions obtenus. Il n'est pas nécessaire ici d'effectuer une conversion entre différents domaines, par exemple entre le domaine des angles d'Euler généralisés et celui des quaternions puisque les doubles quaternions utilisés pour la quantification sont déjà obtenus après décodage.

Dans le mode de réalisation présenté ici, les quaternions utilisés à l'étape d'interpolation du bloc 360 de la figure 3 proviennent d'un décodage local des quaternions quantifiés dans le bloc 340. Ce décodage local est en effet effectué pour que l'étape d'interpolation soit effectuée de la même façon coté codeur que coté décodeur afin d'obtenir au décodeur une reconstruction parfaite (en l'absence de bruit de codage introduit par les blocs 380 et 480).

Cependant, dans une variante de réalisation, les quaternions utilisés pour l'étape d'interpolation du bloc 360 peuvent provenir directement de l'étape de conversion du bloc 330 sans passer par les étapes de quantification et de quantification inverse. Cette interpolation peut être effectuée comme décrite dans la demande de brevet citée précédemment. D'autres modes de réalisation de l'interpolation sont possibles.

Une fois l'interpolation calculée séparément pour les deux quaternions $q_1$ et $q_2$, une matrice de rotation de dimension 4x4 est calculée, par exemple en calculant explicitement le produit matriciel $M = Q_1 Q_2^{\star} = Q_2 Q_1^{\star}$ après avoir formé les matrices $Q_1$ et $Q_2^{\star}$ (ou $Q_2$ et $Q_1^{\star}$) comme définies précédemment.

Dans une variante de réalisation, les 6 angles, $\omega_1$, $\theta_1$, $\varphi_1$, $\omega_2$, $\theta_2$, $\varphi_2$ obtenus pourront être quantifiés par une méthode de quantification vectorielle avec support « hyper-rectangulaire » ($[0,\pi/2]$x$[-\pi,\pi]$x$[0,\pi]$x$[0,\pi]$x$[-\pi,\pi]$x$[0,\pi]$), en tenant compte des intervalles respectifs tels que définis ci-dessus, par exemple selon la méthode TCQ décrite dans J.P. Adoul, Lattice and Trellis Coded Quantizations for efficient Coding of Speech, In: Ayuso, Soler (eds), Speech Recognition and Coding, NATO ASI Series, 1995.

Dans un autre exemple de réalisation une quantification scalaire pourra être mise en œuvre pour les deux angles $\omega_1$ et $\omega_2$ (correspondant à la partie réelle des quaternions) et une quantification sphérique en dimension 3 séparée pourra être effectuée pour les autres angles, $\theta_1$, $\varphi_1$ et $\theta_2$, $\varphi_2$, correspondants aux parties imaginaires des quaternions. Le dictionnaire de quantification peut être en général n'importe discrétisation de la sphère par un nombre finis de points, mais on aura avantage à prendre une discrétisation quasi-uniforme (de type Lebedev, t-design, etc.) pour de meilleures performances, et dans des variantes une discrétisation de type lat-long (latitude-longitude) pourra être aussi utilisée.

On décrit ci-dessous une approche lat-long :

Les composantes $(b_i, c_i, d_i)$ sont vues comme un vecteur cartésien 3D, qui peut être mis sous forme de coordonnées sphériques $(r_i, \theta_i, \varphi_i)$. Le rayon $r_i$ est donné par $r_i = \sin(\omega_i)$. Les angles $\theta_i$, $\varphi_i$ sont déterminés comme décrit dans l'invention, ils correspondent respectivement à la longitude et la lattitude. Ces angles peuvent être quantifiés selon le dictionnaire (avec des angles en degrés) comme décrit à la section 3.2 dans l'article Perotin et al., CRNN-based multiple DoA estimation using acoustic intensity features for Ambisonics recordings, IEEE Journal of Selected Topics in Signal Processing, 2019:

$$\hat{\varphi}_n = -90 + \frac{n}{I(\alpha)} 180, n = 0, \dots, I(\alpha)$$

$$\hat{\theta}_m^n = -180 + \frac{m}{J_n(\alpha)+1} 360, m = 0, \dots, J_n(\alpha)$$

où

$$I(\alpha) = \left\lfloor \frac{180}{\alpha} \right\rfloor \text{ et } J_n(\alpha) = \left\lfloor \frac{360}{\alpha} cos\hat{\varphi}_n \right\rfloor$$

On notera cependant que la latitude est définie dans l'article Perotin et al. avec une fonction arcsin, donc il convient d'appliquer la conversion 90 - $\hat{\varphi}_n$ pour coder l'angle $\varphi_i$ défini ici - sans perte de généralité - avec une fonction arccos.

Cela implique une quantification conditionnelle de 2 angles où on code d'abord la latitude $\varphi_i$ en trouvant le plus proche voisin parmi 90 - $\hat{\varphi}_n$, $n = 0, \dots, I(\alpha)$ et ensuite on code la longitude $\theta_i$ en trouvant le plus proche voisin parmi $\hat{\theta}_m^n$ en fonction de l'indice n sélectionné.

Le nombre de bits nécessaires est $\lceil log_2 N(\alpha) \rceil$ où

$$N(\alpha) = \sum_{n=0}^{I(\alpha)} J_n(\alpha)$$

Le dictionnaire par exemple est de taille $N(\alpha) = 429$, 1687 ou 4645 pour $\alpha = 10$, 5 ou 3 degrés (respectivement), soit 9, 11 ou 13 bits (en arrondissant à l'entier supérieur). D'autres niveaux de reconstructions 90 - $\hat{\varphi}_n$ et/ou $\hat{\theta}_m$ (et d'autres seuils de décision) peuvent être utilisés pour un dictionnaire de taille $N(\alpha)$ donnée.

Dans des variantes de l'invention, on code à l'étape E330 un quaternion unitaire $q_i = (a_i, b_i, c_i, d_i)$, en utilisant les coordonnées sphériques en dimension 4 (en notant ici que le rayon est fixé à 1 car le quaternion $q_i$ est unitaire):

$$a_i = \cos(\phi_{i0})$$

$$b_i = \sin(\phi_{i0})\cos(\phi_{i1})$$

$$c_i = \sin(\phi_{i0})\sin(\phi_{i1})\cos(\phi_{i2})$$

$$d_i = \sin(\phi_{i0})\sin(\phi_{i1})\sin(\phi_{i2})$$

où $\phi_{i0}$ est sur $[0, \pi]$ ou $[0, \pi/2]$ selon l'invention, $\phi_{i1}$ sur $[0, \pi]$ et $\phi_{i2}$ sur $[0, 2\pi]$.

Les coordonnées sphériques peuvent être déterminées par :

$$\phi_{i0} = arccos(a_i)$$

$$\phi i_1 = arccos(b_i/\sqrt{b_i^2 + c_i^2 + d_i^2})$$

$$\phi i_2 = \begin{cases} arccos(c_i/\sqrt{c_i^2 + d_i^2}) & d_i \geq 0 \\ 2\pi - arccos(c_i/\sqrt{c^2 + d_i^2}) & d_i < 0 \end{cases}$$

Les cas spéciaux où certaines composantes sont nulles (ex : $c_i = 0$, $d_i = 0$) ne sont pas traités ici mais par convention l'angle correspondant à des valeurs nulles peut être mis à 0.

Pour cette variante, tous les modes de réalisation décrits précédemment pour le codage de 6 angles (séparé ou conjoint) s'appliquent.

Dans des variantes d'autres définitions de coordonnées sphériques pourront être utilisées.

Dans un deuxième mode de réalisation, une quantification vectorielle sphérique de dimension 4 est mise en œuvre.

Le fait que l'on ait forcé une composante du premier quaternion à être positive permet de connaitre le signe dudit quaternion et de ne coder que le quaternion concerné positif, le quaternion négatif correspondant à la même rotation. Ainsi, pour le premier quaternion, une quantification vectorielle hémisphérique est suffisante et permet de réduire le débit par rapport à une quantification sphérique.

Ainsi $q_1$ peut être quantifié avec un dictionnaire hémisphérique (dans lequel la première composante de chaque mot de code est positive) et $q_2$ avec un dictionnaire sphérique. Les rôles de $q_1$ et $q_2$ peuvent bien évidemment être intervertis pour forcer une composante à être positive et pour la quantification.

Des exemples de dictionnaires peuvent être donnés par des points prédéfinis dans des polyèdres réguliers ou non de dimension 4. Un exemple simple de dictionnaire sphérique en dimension 4 sur 7 bits est donné par les 120 sommets d'une « 600-cell » qui correspondent à la combinaison des points suivants :

- 8 permutations signées de $(\pm 1, 0, 0, 0)$
- 16 permutations signées de $(\pm\frac{1}{2}, \pm\frac{1}{2}, \pm\frac{1}{2}, \pm\frac{1}{2})$
- 96 permutations paires de $(\pm\frac{\sqrt{5}+1}{4}, \pm\frac{\sqrt{5}-1}{4}, \pm\frac{1}{2}, 0)$

La version hémisphérique d'un tel dictionnaire comprend les 60 points suivants (sur 6 bits):

- 4 permutations signées du « vecteur directeur » (ou leader) $(\pm 1, 0, 0, 0)$ avec la première composante positive
- 8 permutations signées du leader $(\pm\frac{1}{2}, \pm\frac{1}{2}, \pm\frac{1}{2}, \pm\frac{1}{2})$ avec la première composante positive
- 48 permutations paires signées du leader $(\pm\frac{\sqrt{5}+1}{4}, \pm\frac{\sqrt{5}-1}{4}, \pm\frac{1}{2}, 0)$ avec la première composante positive

Etant donné un dictionnaire sphérique ou hémisphérique, la quantification consiste à d'abord trouver le plus proche voisin du quaternion à coder ; en général cette opération peut être optimisée en exploitant la structure algébrique sous-jacente et en ne comparant que des « vecteurs absolus » par produit scalaire. La quantification comprend également une étape explicite d'indexation (calcul de l'indice de quantification identifiant le mot de code le plus proche), et en général l'indice est calculé par un indice de permutation (signée) et un offset dépendant du vecteur absolu représentant le plus proche voisin. Ces concepts sont considérés comme déjà connus de l'homme de l'art. Ce mode de réalisation par quantification vectorielle a comme désavantage de devoir explicitement déterminer l'indice de quantification et aussi de nécessité de stocker certains éléments décrivant le dictionnaire de quantification. Pour pouvoir coder un quaternion avec un budget autour de 25 bits, le dictionnaire de dimension 4 doit combiner un très grand nombre de combinaisons de points représentants (leaders). Aussi, dans d'autres variantes, on pourra appliquer une quantification scalaire conditionnelle.

On reprend ici la définition des coordonnées sphériques en dimension 4 :

$$a_i = \cos(\phi_{i0})$$

$$b_i = \sin(\phi_{i0})\cos(\phi_{i1})$$

$$c_i = \sin(\phi_{i0})\sin(\phi_{i1})\cos(\phi_{i2})$$

$$d_i = \sin(\phi_{i0})\sin(\phi_{i1})\sin(\phi_{i2})$$

où $\phi_{i0}$ est sur $[0, \pi]$ ou $[0, \pi/2]$ selon l'invention, $\phi_{i1}$ sur $[0, \pi]$ et $\phi_{i2}$ sur $[0, 2\pi]$.

On généralise en dimension 4 le principe de la quantification sphérique en dimension 3 par un dictionnaire de type lat-long. Pour ce faire, l'angle $\phi_{i0}$ est converti en degrés et quantifié avec un dictionnaire scalaire de pas uniforme qui dépend de l'intervalle:

- sur un intervalle $[0, 180]$ :

$$\hat{\phi}_{i0} = \frac{n}{I(\alpha)} 180, n = 0, \dots, I(\alpha)$$

où $I(\alpha) = \left\lfloor \frac{180}{\alpha} \right\rfloor$.

- sur un intervalle [0, 90] :

$$\hat{\phi}_{i0} = \frac{n}{I(\alpha)} 90, n = 0, \dots, I(\alpha)$$

où $I(\alpha) = \left\lfloor \frac{90}{\alpha} \right\rfloor$. Le paramètre $\alpha$ indique la résolution angulaire (par exemple $\alpha$=5 degrés).

Ensuite, l'angle $\phi_{i1}$ est converti en degrés et quantifié avec un dictionnaire scalaire sur l'intervalle [0, $\pi$] dont le nombre de sous-intervalles (et de niveaux de reconstructions $\hat{\phi}_{i1}$) dépend de la valeur de $\hat{\phi}_{i0}$. Enfin, l'angle $\phi_{i2}$ est converti en degrés et quantifié avec un dictionnaire scalaire sur l'intervalle [0, $2\pi$] dont le nombre de sous-intervalles (et de niveaux de reconstruction $\hat{\phi}_{i2}$) dépend de la valeur de $\hat{\phi}_{i0}$ et $\hat{\phi}_{i1}$. Les dictionnaires de quantification séparés définissant $\hat{\phi}_{i1}$ et $\hat{\phi}_{i2}$ peuvent être dans un exemple définis à partir d'un dictionnaire de quantification sphérique en dimension 3 de type lat-long de sorte que leur taille $N(\alpha')$ soit adapté en fonction de la valeur de $\hat{\phi}_{i0}$. L'intérêt de cette variante est en particulier d'avoir un élément du dictionnaire de quantification vectorielle qui correspond à $q_1 = q_2$ = (1,0,0,0) et aussi de pouvoir répartir plus uniformément les éléments du dictionnaire de quantification en dimension 4 comparativement à une quantification scalaire indépendante pour chacun des angles $\phi_{i0}$, $\phi_{i1}$, $\phi_{i2}$.

Dans une autre variante de codage à débit variable, on rajoute une étape de sélection de type de codage et décision de multiplexage des indices. On définit un bit qui peut indiquer que le double quaternion est codé par $q_1 = q_2$ = (1,0,0,0) (définies comme valeurs par défaut) - ce qui indique par la même occasion que la matrice de transformation est une matrice identité. Dans ce cas, le budget de bits pour coder un double quaternion selon le mode de réalisation principal varie entre deux valeurs possibles : 1 bit si le double quaternion est codé par les valeurs $q_1 = q_2$ = (1,0,0,0) et 52 bits (1+51) autrement ; dans ce dernier cas on applique l'invention décrite précédemment et dans des variantes, le dictionnaire de quantification utilisé pourra ne pas contenir le cas $q_1 = q_2$ = (1,0,0,0) puisque ce cas est couvert quand un seul bit est codé.

De plus, le bloc de multiplexage (390) rajoute un bit supplémentaire pour indiquer le mode de codage utilisé.

On présente maintenant un mode de réalisation spécifique au cas d'une matrice de rotation 3x3. L'invention décrite précédemment s'applique également avec, dans ce cas, $q_1 = q$ et $q_2 = -q$. On ne code donc qu'un seul quaternion (par exemple $q_1$) et avantageusement on utilise l'indication d'absence de composante positive F$_1$=0 pour économiser un bit. Avec le budget décrit dans le mode de réalisation on obtient donc un codage sur 25 bits. On retrouve toutes les variantes de codage possible dans le cas 3x3 (quantification vectorielle sphérique avec dictionnaire hémisphérique, conversion en coordonnées sphériques et quantification des angles, etc.).

Dans une variante de ce mode de réalisation, on pourra aussi rajouter une étape de sélection de type de codage et décision de multiplexage des indices. On définit un bit global qui peut indiquer que le quaternion est codé par $q$ = (1,0,0,0) . Dans ce cas, le budget de bits pour coder un quaternion selon cette variante varie entre deux valeurs possibles : 1 bit si le quaternion est codé par $q$ = (1,0,0,0) et 26 bits (1+25) autrement.

Dans tous les variantes décrites précédemment pour le codage, on pourra également utiliser de façon optionnelle un codage entropique (par exemple de type Huffman ou arithmétique) après la quantification, ce qui peut en général réduire le débit moyen au prix d'un débit variable.

On décrit à présent le procédé de décodage et en particulier l'étape de quantification inverse effectuée par le bloc 400 de la figure 4. La figure 6a en décrit un mode de réalisation.

Les indices de quantification idx1, idx2 et idx3 pour chacun des quaternions i sont reçus au décodeur en E601, E602 et E603 et décodés en E611, E612, e613 respectivement.

Les paramètres de largeur d'intervalle de quantification F et d'existence de valeurs positives et négatives de l'intervalle T sont également obtenus en E611, E612 et E613. L'indication d'absence de composante positive F$_i$ est également obtenue en E611.

Ainsi, en E611, on obtient F$_i$ comme valeur de F et 0 comme valeur de T. En E612, on obtient 1 comme valeur de F et 1 comme valeur de T et en E613, on obtient 1 comme valeur de F et 0 comme valeur de T.

Les étapes de quantification inverse effectuées en E611, E612 et E613 permettent de décoder les angles $\omega_i$ en E621, $\theta_i$ en E622 et $\varphi_i$ en E623.

Les composantes des quaternions respectifs $a_i$, $b_i$, $c_i$, $d_i$ sont ensuite décodées en E630 à partir des angles ainsi décodés, selon les formules suivantes :

$$a_i = \cos(\omega_i)$$

$$b_i = \cos(\theta_i)\sin(\varphi_i)\sin(\omega_i)$$

$$c_i = \sin(\theta_i)\sin(\varphi_i)\sin(\omega_i)$$

$$d_i = \cos(\varphi_i)\sin(\omega_i)$$

L'étape de quantification inverse d'un angle, telle que l'étape E611, E612 ou E613 est maintenant détaillée dans l'organigramme de la figure 6b.

En partant, en E640, des valeurs respectives de idx (indice que quantification d'un angle), T et F telles que définies ci-dessus, les paramètres N et N' sont définis en E641. N= $2^R$ et N'=N/2 avec R, une valeur de bits fixée à 8 bits dans cet exemple de réalisation. En E642, on vérifie la valeur de F. Si F=0, la largeur de l'intervalle de quantification est réduite de moitié et a donc pour valeur maximale $\pi/2$ en E643. Dans le cas contraire, si F=1, l'intervalle de quantification n'est pas réduit et sa valeur maximale en E644 est de $\pi$.

En E645, la valeur d'un paramètre de signe s est initialisée à la valeur 0.

En E646, on vérifie la valeur de T. Si T est égal à 1, on met à jour la valeur de $N$ en E648 (N=N').

En E649, on vérifie la valeur de idx. Si celle-ci n'est pas supérieure ou égale à N', alors à l'étape E670, la valeur de s est mise à 1 et celle de idx est mise à jour en la soustrayant de $N'$. En effet les indices de 0 à N'-1 correspondent aux valeurs positives et les indices de $N'$ à $N$ - 1 aux valeurs négatives.

En E671, un pas de quantification d est défini comme étant la valeur maximale de l'intervalle sur $N$ - 1.

Dans le cas où T est égal à 0 en E646, on passe directement à l'étape E671.

Dans le cas où idx est supérieur ou égal à N' en E649, on passe directement à l'étape E671.

En E672, on calcule la valeur de a comme étant la valeur suivante : $(-1)^s.idx.d$

On décode ainsi, la valeur de *a,* c'est-à-dire la valeur de l'angle en E673.

On a illustré sur la figure 7 un dispositif de codage DCOD et un dispositif de décodage DDEC, au sens de l'invention, ces dispositifs étant duals l'un de l'autre (dans le sens de « réversibles ») et reliés l'un à l'autre par un réseau de communication RES.

Dans d'autres modes de réalisation, l'étape de quantification inverse du procédé de décodage, effectuée par le bloc 400 de la figure 4 est adaptée à la méthode de quantification effectuée au codage.

Ainsi, une quantification vectorielle sphérique inverse pourra être effectuée. Une indication d'existence d'une composante positive reçue au décodage permet de savoir si une quantification hémisphérique a été effectuée au codage pour coder un premier quaternion. Dans ce cas, la quantification inverse sera une quantification vectorielle hémisphérique inverse pour décoder ce premier quaternion.

De même, dans le cas où une quantification scalaire conditionnelle utilisant des coordonnées sphériques est utilisée au codeur, le décodeur effectuera une quantification inverse pour retrouver ces coordonnées sphériques et décoder les quaternions correspondants.

Le dispositif de codage DCOD comporte un circuit de traitement incluant typiquement :

- une mémoire MEM1 pour stocker des données d'instructions d'un programme informatique au sens de l'invention (ces instructions pouvant être réparties entre le codeur DCOD et le décodeur DDEC) ;
- une interface INT1 de réception d'un signal multicanal d'origine **B,** par exemple un signal ambisonique réparti sur différents canaux (par exemple quatre canaux W, Y, Z, X à l'ordre 1) en vue de son codage en compression au sens de l'invention ;
- un processeur PROC1 pour recevoir ce signal et le traiter en exécutant les instructions de programme informatique que stocke la mémoire MEM1, en vue de son codage ; et
- une interface de communication COM 1 pour transmettre les signaux codés via le réseau.

Le dispositif de décodage DDEC comporte un circuit de traitement propre, incluant typiquement :

- une mémoire MEM2 pour stocker des données d'instructions d'un programme informatique au sens de l'invention (ces instructions pouvant être réparties entre le codeur DCOD et le décodeur DDEC comme indiqué précédemment) ;
- une interface COM2 pour recevoir du réseau RES les signaux codés en vue de leur décodage en compression au sens de l'invention ;
- un processeur PROC2 pour traiter ces signaux en exécutant les instructions de programme informatique que stocke la mémoire MEM2, en vue de leur décodage ; et

- une interface de sortie INT2 pour délivrer les signaux décodés par exemple sous forme de canaux ambisoniques W...X, en vue de leur restitution.

Bien entendu, cette figure 7 illustre un exemple d'une réalisation structurelle d'un codec (codeur ou décodeur) au sens de l'invention. Les figures 3 à 6 commentées ci-dessus décrivent en détails des réalisations plutôt fonctionnelles de ces codecs.

**Revendications**

1. Procédé de codage d'un signal sonore multicanal, comportant une formation d'une matrice de transformation sous la forme d'une matrice de rotation à appliquer aux signaux d'entrée, une quantification de la matrice de rotation, un codage des signaux transformés après application de la matrice de rotation, dans lequel la quantification de la matrice de rotation comporte les opérations suivantes :

   - convertir (E300) la matrice de rotation dans le domaine des quaternions avec au moins un premier quaternion ;
   - forcer (E320) ledit premier quaternion à avoir une composante positive ;
   - convertir le au moins un premier quaternion en coordonnées sphériques, une des coordonnées sphériques étant associée à la composante forcée positive du premier quaternion ;
   - quantifier (E330) les coordonnées sphériques obtenues, la coordonnée sphérique associée à la composante forcée positive du premier quaternion étant quantifiée sur un intervalle de demi-longueur.

2. Procédé selon la revendication 2, dans lequel la composante positive dudit premier quaternion est sa composante réelle.

3. Procédé selon l'une des revendications 1 à 2, dans lequel la matrice de rotation est convertie en double quaternion, un premier quaternion pour lequel une composante est forcée à être positive et un deuxième quaternion.

4. Procédé selon la revendication 3, dans lequel la quantification du premier quaternion utilise un bit de moins que la quantification du deuxième quaternion.

5. Procédé selon la revendication 3, dans lequel la conversion en coordonnées sphériques de chacun des deux quaternions du double quaternion donne trois angles, et la quantification de l'angle associé à la composante positive du premier quaternion s'effectue selon un intervalle de demi-longueur par rapport à l'intervalle utilisé pour quantifier la même composante dans le deuxième quaternion.

6. Procédé selon la revendication 5, dans lequel la quantification des six angles obtenus s'effectue par quantification scalaire uniforme.

7. Procédé selon la revendication 5, dans lequel la quantification des six angles obtenus s'effectue par quantification vectorielle à support hyper-rectangulaire.

8. Procédé selon l'une des revendications précédentes, dans lequel une indication binaire est en outre codée pour indiquer si le au moins un premier quaternion prend des valeurs par défaut.

9. Procédé de décodage d'un signal sonore multicanal, comportant la réception de de signaux codés d'un signal multicanal et comportant en outre les opérations :

   - recevoir (E601, E602, E603) des paramètres de coordonnées sphériques quantifiés d'un ensemble d'au moins un premier quaternion et une indication d'existence d'une composante positive (E611) ;
   - décoder (E611, E612, E613) le au moins un premier quaternion à partir des paramètres quantifiés reçus en prenant un intervalle de quantification de demi-longueur pour décoder une coordonnée sphérique associée à la composante positive indiquée ;
   - construire (462) une matrice de rotation inverse à partir du au moins un premier quaternion décodé ;
   - appliquer (420) ladite matrice de rotation inverse aux signaux issus codés reçus, avant un décodage desdits signaux.

10. Dispositif de codage comportant un circuit de traitement pour la mise en œuvre des étapes du procédé de codage selon l'une des revendications 1 à 8.

11. Dispositif de décodage comportant un circuit de traitement pour la mise en œuvre des étapes du procédé de décodage selon la revendication 9.

12. Support de stockage, lisible par un processeur, mémorisant un programme informatique comportant des instructions pour l'exécution du procédé de codage selon l'une des revendications 1 à 8 ou du procédé de décodage selon la revendication 9.

**Patentansprüche**

1. Verfahren zum Codieren eines mehrkanaligen Audiosignals, umfassend ein Bilden einer Transformationsmatrix in Form einer Rotationsmatrix, die auf die Eingangssignale anzuwenden ist, ein Quantisieren der Rotationsmatrix, ein Codieren der transformierten Signale nach Anwenden der Rotationsmatrix, wobei das Quantisieren der Rotationsmatrix die folgenden Operationen umfasst:

   - Umwandeln (E300) der Rotationsmatrix in den Bereich der Quaternionen mit mindestens einem ersten Quaternion;
   - Zwingen (E320) des ersten Quaternions, eine positive Komponente aufzuweisen;
   - Umwandeln des mindestens einen ersten Quaternions in sphärische Koordinaten, wobei eine der sphärischen Koordinaten der erzwungenen positiven Komponente des ersten Quaternions zugeordnet ist;
   - Quantisieren (E330) der erhaltenen sphärischen Koordinaten, wobei die der erzwungenen positiven Komponente des ersten Quaternions zugeordnete sphärische Koordinate über ein Intervall mit halber Länge quantisiert wird.

2. Verfahren nach Anspruch 2, wobei die positive Komponente des ersten Quaternions seine reale Komponente ist.

3. Verfahren nach einem der Ansprüche 1 bis 2, wobei die Rotationsmatrix in ein Doppelquaternion umgewandelt wird, ein erstes Quaternion, bei dem eine Komponente erzwungenermaßen positiv ist, und ein zweites Quaternion.

4. Verfahren nach Anspruch 3, wobei das Quantisieren des ersten Quaternions ein Bit weniger als das Quantisieren des zweiten Quaternions verwendet.

5. Verfahren nach Anspruch 3, wobei das Umwandeln jedes der beiden Quaternionen des Doppelquaternions in sphärische Koordinaten drei Winkel ergibt und das Quantisieren des der positiven Komponente des ersten Quaternions zugeordneten Winkels gemäß einem Intervall mit halber Länge in Bezug auf das zum Quantisieren derselben Komponente in dem zweiten Quaternion verwendete Intervall erfolgt.

6. Verfahren nach Anspruch 5, wobei das Quantisieren der sechs erhaltenen Winkel durch gleichförmiges skalares Quantisieren erfolgt.

7. Verfahren nach Anspruch 5, wobei das Quantisieren der sechs erhaltenen Winkel durch vektorielles Quantisieren mit hyperrechteckigem Träger erfolgt.

8. Verfahren nach einem der vorhergehenden Ansprüche, wobei ferner eine binäre Angabe codiert wird, um anzugeben, ob das mindestens eine erste Quaternion Standardwerte annimmt.

9. Verfahren zum Decodieren eines mehrkanaligen Audiosignals, umfassend das Empfangen von codierten Signalen eines mehrkanaligen Signals und umfassend ferner die folgenden Operationen:

   - Empfangen (E601, E602, E603) der Parameter von quantisierten sphärischen Koordinaten einer Menge mit mindestens einem ersten Quaternion und einer Angabe des Vorliegens einer positiven Komponente (E611);
   - Decodieren (E611, E612, E613) des mindestens einen ersten Quaternions ausgehend von den empfangenen quantisierten Parametern, indem ein Quantisierungsintervall mit halber Länge genommen wird, um eine der angegebenen positiven Komponente zugeordnete sphärische Koordinate zu decodieren;
   - Erstellen (462) einer inversen Rotationsmatrix ausgehend von dem mindestens einen decodierten ersten Quaternion;

- Anwenden (420) der inversen Rotationsmatrix auf die empfangenen codierten hervorgegangenen Signale vor einem Decodieren der Signale.

10. Codiervorrichtung, umfassend eine Verarbeitungsschaltung zur Implementierung der Schritte des Verfahrens zum Codieren nach einem der Ansprüche 1 bis 8.

11. Decodiervorrichtung, umfassend eine Verarbeitungsschaltung zur Implementierung der Schritte des Verfahrens zum Decodieren nach Anspruch 9.

12. Speichermedium, das von einem Prozessor lesbar ist und das ein Computerprogramm speichert, das Anweisungen zur Ausführung des Verfahrens zum Codieren nach einem der Ansprüche 1 bis 8 oder des Verfahrens zum Decodieren nach Anspruch 9 umfasst.

**Claims**

1. Method for encoding a multichannel audio signal, comprising forming a transformation matrix in the form of a rotation matrix to be applied to the input signals, quantizing the rotation matrix, encoding the transformed signals after applying the rotation matrix, wherein quantizing the rotation matrix comprises the following operations:

   - converting (E300) the rotation matrix in the quaternion domain with at least one first quaternion;
   - forcing (E320) said first quaternion to have a positive component;
   - converting the at least one first quaternion into spherical coordinates, with one of the spherical coordinates being associated with the positive forced component of the first quaternion;
   - quantizing (E330) the acquired spherical coordinates, with the spherical coordinate associated with the positive forced component of the first quaternion being quantized over a half-length interval.

2. Method according to Claim 2, wherein the positive component of said first quaternion is its real component.

3. Method according to any of Claims 1 to 2, wherein the rotation matrix is converted into a dual quaternion, a first quaternion for which a component is forced to be positive and a second quaternion.

4. Method according to Claim 3, wherein the quantization of the first quaternion uses one bit less than the quantization of the second quaternion.

5. Method according to Claim 3, wherein converting each of the two quaternions of the dual quaternion into spherical coordinates yields three angles, and the quantization of the angle associated with the positive component of the first quaternion is carried out at a half-length interval relative to the interval used to quantize the same component in the second quaternion.

6. Method according to Claim 5, wherein the quantization of the six acquired angles is carried out by uniform scalar quantization.

7. Method according to Claim 5, wherein the quantization of the six acquired angles is carried out by vector quantization with a hyper-rectangular support.

8. Method according to any of the preceding claims, wherein a binary indication is also encoded in order to indicate whether the at least one first quaternion assumes default values.

9. Method for decoding a multichannel audio signal, comprising receiving encoded signals from a multichannel signal and further comprising the following operations:

   - receiving (E601, E602, E603) parameters of quantized spherical coordinates of a set of at least one first quaternion and an indication of the existence of a positive component (E611);
   - decoding (E611, E612, E613) the at least one first quaternion from the received quantized parameters by taking a half-length quantization interval in order to decode a spherical coordinate associated with the indicated positive component;
   - constructing (462) an inverse rotation matrix from the at least one first decoded quaternion;

- applying (420) said inverse rotation matrix to the received issued encoded signals, before decoding said signals.

10. Encoding device comprising a processing circuit for implementing the steps of the encoding method according to any of Claims 1 to 8.

11. Decoding device comprising a processing circuit for implementing the steps of the decoding method according to Claim 9.

12. Processor-readable storage medium storing a computer program comprising instructions for executing the encoding method according to any of Claims 1 to 8 or the decoding method according to Claim 9.

FIG.1

FIG.2

FIG.3

FIG.4

$$q1 = (a_1, b_1, c_1, d_1)$$
$$q2 = (a_2, b_2, c_2, d_2)$$

E300

$a_1 < 0?$ — non

E310

oui

$$q1 = -q1$$
$$q2 = -q2$$

E320

Cod. $q_1$ & $q_2$

E330

FIG5a

$$q1 = (a_1, b_1, c_1, d_1)$$
$$q2 = (a_2, b_2, c_2, d_2)$$

E380

E330

E381

$$F_1 = 0$$
Cod. $q_1$

$$F_2 = 1$$
Cod. $q_2$

E382

FIG.5b

$$q_i = (a_i, b_i, c_i, d_i)$$

E510

$$\omega_{ii} = \arccos(a_i)$$

$$\theta_i = arctan2(c_i, b_i)$$

$$\varphi_i = \arccos(d_i/\sqrt{b_i^2 + c_i^2 + d_i^2})$$

E520

E531

$F_i$

Quant. $\omega_i, \theta_i, \varphi_i$

E530

FIG.5c

E381/E382

FIG.5d

E530

E531

$F_i$

E540

$$\omega_i, \theta_i, \varphi_i$$

Quant. Ang.
$a = \omega_i$
$F = F_i$
$T = 0$

Quant. Ang.
$a = \theta_i$
$F = 1$
$T = 1$

Quant. Ang.
$a = \varphi_i$
$F = 1$
$T = 0$

E541

E542

E543

E551 | $idx_{i1}$

E552 | $idx_{i2}$

E553 | $idx_{i3}$

FIG.5e

E601 ⌐ idx$_{i1}$

E602 ⌐ idx$_{i2}$

E603 ⌐ idx$_{i3}$

Dec. idx

F= F$_i$
T= 0

Dec. idx

F= 1
T= 1

Dec. idx

F= 1
T= 0

E611

E612

E613

E621 ⌐ $\omega_i$

E622 ⌐ $\theta_i$

E623 ⌐ $\varphi_i$

$$a_i = \cos(\omega_i)$$

$$b_i = \cos(\theta_i)\sin(\varphi_i)\sin(\omega_i)$$

$$c_i = \sin(\theta_i)\sin(\varphi_i)\sin(\omega_i)$$

$$d_i = \cos(\varphi_i)\sin(\omega_i)$$

E630

FIG.6a

E640 — idx, T, F

E641 — $N = 2^R$
$N' = N/2$

E642 — $F = 0?$ — non

oui

E644 — $maxval := \pi$

E643 — $maxval := \dfrac{\pi}{2}$

E645 — $s := 0$

E646 — $T = 1?$ — non

oui

E648 — $N = N'$

E649 — $idx \geq N'?$ — non

oui

E670 — $s := 1$
$idx := idx - N'$

E671 — $d := \dfrac{maxval}{N-1}$

E672 — $a: (-1)^s . idx . d$

E673 — a

FIG.6b

M E M 1 — PROC 1 — I N T 1 — W
Y
Z
X

COM 1

RES

COM 2

PROC 2 — M E M 2

DDEC

INT 2

W' Y' Z' X'

FIG.7

## RÉFÉRENCES CITÉES DANS LA DESCRIPTION

**Documents brevets cités dans la description**

- WO 2020177981 A

**Littérature non-brevet citée dans la description**

- **DAVID K. HOFFMAN** ; **RICHARD C. RAFFENETTI** ; **KLAUS RUEDENBERG**. Generalization of Euler Angles to N-Dimensional Orthogonal Matrices. *Journal of Mathematical Physics*, 1972, vol. 13, 528

- Lattice and Trellis Coded Quantizations for efficient Coding of Speech. **J.P. ADOUL**. Speech Recognition and Coding, NATO ASI Series. 1995
- **EROTIN et al.** CRNN-based multiple DoA estimation using acoustic intensity features for Ambisonics recordings. *IEEE Journal of Selected Topics in Signal Processing*, 2019